# EUROPÄISCHE PATENTSCHRIFT

(11) **EP 2 943 825 B1**
(45) Veröffentlichungstag und Bekanntmachung des Hinweises auf die Patenterteilung: **12.12.2018**
(21) Anmeldenummer: 14700377.6
(22) Anmeldetag: 13.01.2014
(51) Int. Cl.: G02B 6/138, G02B 6/122, C08G 77/28, C08L 83/16, C09D 183/16, B29C 67/00

(54) **SCHICHTEN ODER DREIDIMENSIONALE FORMKÖRPER MIT ZWEI BEREICHEN UNTERSCHIEDLICHER PRIMÄR- UND/ODER SEKUNDÄRSTRUKTUR UND VERFAHREN ZU DEREN HERSTELLUNG**
LAYERS OR THREE-DIMENSIONAL SHAPED BODIES HAVING TWO REGIONS OF DIFFERENT PRIMARY AND/OR SECONDARY STRUCTURE AND METHOD FOR PRODUCTION THEREOF
COUCHES OU CORPS MOULÉS TRIDIMENSIONNELS COMPORTANT DEUX ZONES DE STRUCTURES PRIMAIRES ET/OU SECONDAIRES DIFFÉRENTES ET LEUR PROCÉDÉ DE PRODUCTION

(30) Priorität: 11.01.2013 DE 102013100313
(43) Veröffentlichungstag der Anmeldung: 18.11.2015
(73) Patentinhaber: Fraunhofer-Gesellschaft zur Förderung der angewandten Forschung e.V., 80686 München (DE)
(72) Erfinder: WOLTER, Herbert, 97941 Tauberbischofsheim (DE); HOUBERTZ, Ruth, 97074 Würzburg (DE)
(74) Vertreter: Strehl Schübel-Hopf & Partner
(86) Internationale Anmeldenummer: PCT/EP2014/050491
(87) Internationale Veröffentlichungsnummer: WO 2014/108538

(56) Entgegenhaltungen:
- EP-B1- 1 846 527
- WO-A1-2009/021256
- DE-A1-102011 012 412
- US-A1- 2007 049 652

## Beschreibung

Die vorliegende Erfindung betrifft spezielle Schichten oder dreidimensionale Formkörper, die, hergestellt aus nur einem Material, Bereiche mit unterschiedlichen Primärstrukturen (d.h. chemischen Verknüpfungen, z.B. den Vernetzungsgrad beeinflussend oder aufgrund von erfolgten Umordnungen oder Umlagerungen) und/oder Sekundärstrukturen (hierunter soll vorliegend die Ordnung der Moleküle im Formkörperverbund verstanden werden, die z.B. durch Faltungen oder Verdichtungen beeinflusst wird) aufweisen. Die unterschiedliche Primär- und/oder Sekundärstruktur der unterschiedlichen Bereiche bewirkt, dass diese unterschiedliche physikalische oder mechanische Eigenschaften besitzen, zum Beispiel unterschiedliche Brechungsindizes oder einen unterschiedlichen Elastizitätsmodul. In einer spezifischen Ausführungsform ist ein erster Bereich mit vernetzten Strukturen vorhanden, während ein zweiter Bereich das Material in weiterhin (zumindest organisch) unvernetztem Zustand aufweist. Dieses kann anschließend ausgewaschen werden ("Entwicklung" der durch Vernetzung erzeugten Struktur), so dass eine zweidimensionale Schicht oder ein dreidimensionaler Formkörper mit nur einer Primär- bzw. Sekundärstruktur, aber spezifischen Formen, gebildet werden kann. Auf diese Weise können beispielsweise poröse Formkörper oder strukturierte Schichten erzeugt werden, ohne dass für letztere Maskenprozesse erforderlich sind. Die Erfindung betrifft weiterhin Verfahren zum Herstellen dieser Schichten oder Formkörper.

Die Herstellung dreidimensionaler Körper durch Bestrahlen vorbestimmter Volumenpixel (Voxel) in einem Badmaterial mit Hilfe von 2-Photonen-Polymerisation (2PP) ist seit geraumer Zeit bekannt. Erste Versuche gelangen mit rein organischen Materialien. WO 03/037606 A1 beschreibt die Herstellung dreidimensionaler Körper aus Polysiloxanen, die durch hydrolytische Kondensation von Silanen mit über Si-C-gebundenen organischen, durch Strahlung polymerisierbaren Gruppen hergestellt werden können. Grundlage des dort vorgestellten Polymerisationsprozesses ist die Zwei-Photonen-Polymerisation (auch als 2PP bezeichnet), induziert durch eine Zwei-Photonen-Absorption (auch als TPA bezeichnet), wobei festgestellt werden konnte, dass der Wechselwirkungsquerschnitt (die Wahrscheinlichkeit der 2P-Absorption) der eingesetzten Organopolysiloxane hinreichend groß war, um dieses Verfahren zur Erzeugung dreidimensionaler Strukturen, sei es in Form von (ggf. selbsttragenden) Körpern, sei es in Form von oberflächenstrukturierten oder sonstigen Schichten, die ggf. von einem Substrat gehalten werden, einzusetzen. In WO 03/037606 A1 wird eine lithographische Auflösung von ca. 100 nm mittels Femtosekundenlaser-Bestrahlung erwähnt, die jedoch noch nicht optimiert war.

Eine Vielzahl von Veröffentlichungen hat sich inzwischen dieser Thematik gewidmet; das Verfahren hat die früher übliche Stereolithographie durch seine hohe Auflösung, kleinste Strukturen im Bereich von 100 nm oder darunter und die dabei erreichbare sehr gute Oberflächengüte weitgehend abgelöst und verfeinert. Mit 2-Photonen-Polymerisation lassen sich beispielsweise biokompatible, bioresorbierbare oder biodegradierbare Strukturen erzeugen, die als Scaffolds zur Anbindung lebender Zellen oder für Implantate genutzt werden können. Auch diese Materialien können auf entsprechend modifizierten Polysiloxanen basieren, siehe WO 2011/98460 A1. Weitere Vorschläge betreffen die selektive Belichtung von Hydrogelen aus methacrylierten Poly(ε-caprolacton)basierten Oligomeren oder Poly(ethylenglycol)diacrylat mittels 2-PP-Polymerisation, siehe Jenni E. Koskela et al. in Polym. Adv. Technol. 23, 992-1001 (2012). Ein anderer Ansatz ist in WO 2011/147854 A1 offenbart. Diese Druckschrift beschäftigt sich mit der Herstellung strukturierter Formkörper sowie dünner oder auch dickerer Schichten aus auf photochemischem Wege organisch vernetzbaren metallorganischen Verbindungen, aus denen sich durch Sinterung und ggf. nachfolgende physikalische Aktivierung, beispielsweise Polarisation mit Hilfe eines elektrischen Feldes oder, falls magnetische Materialien darin enthalten sind, Aktivierung durch ein Magnetfeld, technisch relevante oxidische Funktionskörper oder -schichten herstellen lassen, z.B. in Form von magnetisch oder piezoelektrisch aktiven Sensoren oder Aktoren oder (Energie-)Wandlern wie Ultraschallwandlern aus PZT (Blei-Zirkonat-Titanat) oder BTO (Bariumtitanat).

In allen genannten Fällen wird der dreidimensionale Körper oder die strukturierte Oberfläche dadurch entwickelt, dass das nicht-belichtete Badmaterial ausgewaschen wird.

Es gibt Fälle, in denen der so hergestellte Körper anschließend in ein anderes Material eingebettet werden soll, das andere physikalische Eigenschaften besitzt. Ein prominentes Beispiel hierfür ist die Herstellung von Wellenleitern, die als "Core" in ein Cladding eingebettet werden müssen, um die gewünschte Brechzahldifferenz zwischen dem Medium des Wellenleiters selbst und dem angrenzenden Medium zu bewirken. Da polymerisierte Polysiloxane in aller Regel eine hohe Transmission für sichtbares Licht und auch angrenzende Bereiche aufweisen, sind sie potentielle Kandidaten für solche Wellenleiter. Dabei ist anzumerken, dass der gesamte Bereich von UV bis IR von Interesse ist: Materialien mit Transmission im sichtbaren oder sehr nahen Infrarot-Bereich sind z.B. für Multimode-Wellenleiter (genutzt wird z.B. eine Wellenlänge von 850 nm) sowie Gebrauchsgegenstände geeignet; Singlemode-Wellenleiter, die im Bereich der Datenübertragung eingesetzt werden, nutzen häufig die Wellenlängen 1310 und 1550 nm. UV-Licht wird im Bereich der blue ray (-DVD) Player eingesetzt. Je kleiner die genutzte Wellenlänge ist, desto engere, feinere Strukturen lassen sich erzeugen, was im Bereich der Datenträger bedeutet, dass sie auf derselben Fläche mehr Daten aufnehmen können als mit größeren Wellenlängen geschriebene.

Wellenleiter werden auch heute noch teilweise durch "klassisches" Belichten erzeugt. So schlagen z.B. Chunfang Ye et al. in Optics Express 20 (6), 6575-6583 (2012) vor, Wellenleiter durch direkt eingeschriebene Lithographie zu erzeugen. Als Basis dienen ihnen Photopolymere, die ursprünglich für die holographische Datenspeicherung entwickelt wurden. Diese Photopolymere umfassen eine feste, aber flexible Matrix sowie die photoaktiven Komponenten, nämlich einen geeigneten Photoinitiator sowie ein Monomer, das durch Reaktion mit dem angeregten Initiator polymerisiert. Die lokale Belichtung des Materials bewirkt, dass sich in den belichteten Bereichen das entstehende Polymer anreichert, während seine Konzentration aufgrund von Diffusionsprozessen in den nicht-belichteten Bereichen abnimmt. Die Autoren sehen hierin die Ursache für einen lokalen Anstieg des Brechungsindex'. Nach Abschluss der selektiven Belichtung wird das gesamte Material belichtet, um verbliebenen Initiator und verbliebenes Monomer "aufzubrauchen", und es entsteht ein chemisch und optisch nicht mehr reaktives Material, dessen optische Eigenschaften sich in den selektiv belichteten Bereichen von den nicht-selektiv belichteten Bereichen unterscheidet. Die beiden Bereiche könnten als "Core" und "Cladding" eines Wellenleiters genutzt werden.

Es hat auch bereits Versuche gegeben, 2PP-Polymerisation für ähnliche Verfahren zu nutzen. J. Kumpfmüller et al. schlagen in Journal of Laser Micro-Nanoengineering 6 (3), 195-198 (2011) vor, ein Silikonpolyetheracrylatharz als Basis zu verwenden, das mit Hilfe eines Rheologie-Additivs thixotrop gemacht wurde. Dieser Mischung wurden Trimethylolpropantriacrylat und ein Photoinitiator zugesetzt. Die Autoren konnten anhand von Phasenkontrasten die Erzeugung von Strukturen zeigen, die sich als Wellenleiter eignen könnten. Auch diese Gruppe geht davon aus, dass die unterschiedlichen Eigenschaften der unterschiedlich belichteten Materialien auf der Diffusion des Monomeren beruhen. Allerdings ist ein thixotropes Material als "Cladding" eines Wellenleiters nicht geeignet, da es mechanisch nicht stabil ist und die optische Qualität häufig zu gering ist.

S. Bichler, S. Feldbacher, R. Woods, V. Satzinger, V. Schmidt, G. Jakopic, G. Langer, W. Kern in Optical Materials 34 (2012) 772-780 stellten ein Material her, dessen Matrix durch Umsetzung eines Hydridosilans mit einem Vinylsilan durch klassische Hydrosilylierung (in Gegenwart eines Platin-Katalysators) erzeugt wurde. Als Monomere dienten Benzylmethacrylat oder Phenylmethacrylat, die aufgrund ihres hohen Brechungsindex' ausgewählt wurden. Ethylenglycol-dimethacrylat diente als Vernetzer für die photoinduzierte Polymerisation. Als Photostarter wurde Irgacure 379 verwendet. In einem ersten Schritt wurde das Material aufgeheizt, wobei sich die Siloxan-Matrix bildete, in der das monomere Material gelöst vorlag. Es folgte eine selektive 2PP-Belichtung zur Erzeugung von optischen Wellenleitern, und schließlich wurde das nicht umgesetzte Monomer durch Vakuumextraktion aus dem Bereich der nicht belichteten Matrix extrahiert, um diese zu stabilisieren. Die photoinduzierte Polymerisationsreaktion der Methacrylat-Monomeren wurde mit Hilfe von FTIR-Spektroskopie und Phasenkontrastmikroskopie beobachtet. Die für die Herstellung der Matrix verwendete Hydrosilylierung führt zu Silicongummi, so dass die erzeugten Wellenleiter-Strukturen wie auch die umgebende Matrix flexibel waren.

US 2007/049652 A1 offenbart eine für "rapid prototyping" geeignete Siliconharzzusammensetzung.
DE 10 2011 012412 A1 offenbart ein Verfahren zur schichtweisen Herstellung von 3D-Strukturen aus photovernetzbaren Materialien.
EP 1 846 527 B1 offenbart die Strukturierung von Materialien mit Hilfe von Multiphotonenpolymerisation, wobei das Material einen flüssigen, ethylenisch ungesättigten Polysilazanvorläufer, ein multifuntionales Thioladditiv, ein weiteres multifunktionales ethylenisch ungesättigtes Additiv und eine durch Multiphotonenbehandung härtbare Zusammensetzung enthält.
WO 2009/021256 A1 offenbart ein Verfahren zur Herstellung von optischen Wellenleitern, bei dem ein Organopolysiloxan und ggf. ein Quevernetzer thermisch oder photochemisch vorpolymerisiert werden und dann eine Strukturierung des Vorpolymerisats erflogt, beispielsweise mit einem Zweiphotonenabsorptionsverfahren.

Es besteht weiterhin ein Bedarf an Materialien zur Herstellung struktureller Netzwerke, die beliebige Formen besitzen können, beispielsweise nano- oder mikrostrukturiert sind, die z.B. im Bereich der 3D optischen Interconnects oder aufgrund von Bereichen mit unterschiedlichem E-Modul nutzbar sind, und die innerhalb eines aus einem einzigen Material hergestellten Festkörpers Bereiche mit unterschiedlichen Primär- und/oder Sekundärstrukturen, wie einleitend definiert, besitzen. Insbesondere besteht ein Bedarf an Materialien, mit denen sich auf sehr einfache Weise feste, stabile Strukturen herstellen lassen, die innerhalb ihrer Struktur (d.h. innerhalb des Festkörpers, aus dem die Struktur besteht) unterschiedliche physikalische, beispielsweise unterschiedliche optische oder mechanische Eigenschaften besitzen.

Die Erfinder der vorliegenden Erfindung konnten überraschenderweise feststellen, dass hier Abhilfe geschaffen werden kann, und zwar durch den Vorschlag, ein mit einem über eine Zwei- oder Mehrphotonenpolymerisation polymerisierbaren organischen Rest modifiziertes polysiloxanhaltiges Material in Kombination mit einer SH-Gruppen enthaltenden Komponente bereitzustellen, welches die Bildung von Thiol-En-Additionsprodukten ermöglicht, und dieses Material einer (örtlich) selektiven 2- oder Mehr-Photonen-Polymerisation und außerdem im Gesamten einem thermischen und/oder photochemischen Bearbeitungsschritt oder einem Waschschritt zu unterwerfen, wobei der erstere der genannten Schritte vor oder nach der 2- oder Mehr-Photonen-Polymerisation durchgeführt wird.

Überraschenderweise konnten die Erfinder nämlich feststellen, dass bei Einsatz dieses Materials und diesem Verfahrensablauf eine selektiv belichtete Struktur eingebettet in ein vollständig verfestigtes Material oder in direkter Nachbarschaft zu diesem entsteht, wobei der selektiv belichtete Bereich im Vergleich zum nicht-selektiv belichteten Bereich strukturelle Änderungen, wie eine unterschiedliche Primär- und/oder Sekundärstruktur, wie oben definiert aufweist, darunter möglicherweise bzw. in manchen Fällen eine höhere Vernetzung der organischen Komponenten im selektiv belichteten Bereich. Die Tatsache, dass der photochemische Bearbeitungsschritt eine Belichtung bis über die Sättigungsgrenze des 2- oder Mehr-Photonen-Polymerisationsprozesses hinaus umfassen kann und dass statt dessen oder zusätzlich eine Belichtung des gesamten Materials vor dem selektiven Belichten erfolgen kann, legt jedoch nahe, dass es sich bei den Unterschieden nicht notwendigerweise um Unterschiede im Grad der Vernetzung des organischen Netzwerks handeln muss, sondern dass andere Effekte, wie Umordnungsprozesse, Umlagerungen oder Verdichtungen (z.B. unter Spannungsabbau) eine Rolle spielen, die möglicherweise auch eine anorganische Nachvernetzung (d.h. die Ausbildung höher molekularer Einheiten) zur Folge haben, obwohl das Material, sofern es nach dem Sol-Gel-Prozess hergestellt ist, bereits zuvor den unter den gewählten Bedingungen möglichen maximalen Kondensationsgrad erreicht hatte. Diese strukturellen Unterschiede haben unterschiedliche physikalische Eigenschaften zur Folge. So kann die selektiv belichtete Struktur einen Brechungsindex aufweisen, der sich von dem des umgebenden bzw. benachbarten, vollständig verfestigten Materials in geeigneter Weise unterscheidet und insbesondere höher ist, so dass die gebildete Struktur z.B. als "Core" und "Cladding" aufweisender Wellenleiter genutzt werden kann, oder die beiden Bereiche können unterschiedliche mechanische Eigenschaften, wie unterschiedliche Elastizitätsmoduli oder Festigkeiten, aufweisen.

Der Ausdruck "2-PP" soll nachstehend jeweils nicht nur die 2-Photonen-Polymerisation umfassen, sondern auch Polymerisationsreaktionen, die unter Absorption von mehr als 2 Photonen erfolgen, also sogenannte Mehr-Photonen-Polymerisationen (M-PP). Die 2- oder Mehr-Photonenpolymerisation wird ausgelöst durch die 2- oder Mehr-Photonen-Absorption, bezeichnet als TPA (2-Photonen-Absorption) bzw. MPA (Mehr-Photonen-Absorption). Nachstehend soll die Verwendung des Ausdrucks TPA jedoch immer bedeuten, dass auch die MPA umfasst ist.

Wird nachstehend der Ausdruck "(Meth)Acryl" verwendet, so ist darunter entweder die Methacrylgruppe und/oder die Acrylgruppe zu verstehen. Vergleichbares gilt für die Ausdrücke "(Meth)Acrylat", "(Meth)Acrylamid" und "(Meth)Acrylthioester".

Eine Vielzahl von teilweise bekannten Materialien kann als modifiziertes polysiloxanhaltiges Material dienen. Bedingung ist, dass das Material Gruppen aufweist, die über eine TPA (bzw. MPA) einer Thiol-en-Addition unter Bildung von entsprechenden Thiol-En-Additions- oder Polymerisationsprodukten unterworfen werden können. Wenn das Material als "En"-Komponente nicht-aromatische C=C-Doppelbindungen aufweist, z.B. isolierte Doppelbindungen, wie Vinylgruppen oder in Allyl- oder Styrylgruppen oder in α,β-ungesättigten Carbonylverbindungen, können diese unter den Bedingungen der TPA durch vorhandene Thiolgruppen angegriffen werden. Derartige Thiol-En-Additions-Reaktionen verlaufen radikalisch. Diejenigen Materialien, die bereits der TPA unterworfen wurden, werden nachfolgend u.a. als "organische, über Zwei- oder Mehrphotonenpolymerisation erhaltene, durch eine Thiol-en-Addition entstandene Strukturen aufweisend" oder "organische, über Zwei- oder Mehrphotonenpolymerisation über eine Thiol-en-Addition verbrückte und/oder polymerisierte Strukturen aufweisend" bezeichnet.

Die Erfinder haben festgestellt, dass für die geeigneten Materialien zumindest ein Teil der Gruppen, die über eine TPA der Thiol-En-Addition zugänglich sind, also zumindest ein Teil der C=C-doppelbindungshaltigen Gruppen und/oder ein Teil der SH-Reste aufweisenden Gruppen, an einem organisch modifizierten Polysiloxan oder einem Derivat davon angebunden sein sollten. Die Anbindungen erfolgen über ein Kohlenstoffatom, und besonders bevorzugt ist die Anbindung über ein Kohlenstoffatom an ein Siliciumatom im Verbund eines organisch modifizierten Polysiloxans oder Kieselsäure(hetero)polykondensats. Möglicherweise beruhen die nun erstmals festgestellten Effekte auf der Tatsache, dass die Verbrückungen, die durch die Thiol-en-Addition bewirkt werden, im erfindungsgemäß einsetzbaren Material aufgrund der Anbindung an die jeweiligen Metalle/Halbmetalle in das anorganische Netzwerk integriert sind und deshalb kein vom anorganischen Netzwerk separates Netzwerk ausbilden können.

Erfindungsgemäß wird damit eine Schicht oder ein dreidimensionaler Formkörper bereitgestellt, umfassend ein Material, das organische, über zwei- oder Mehrphotonenpolymerisation erhaltene, durch eine Thiol-En-Addition entstandene Strukturen aufweist, wobei zumindest ein Teil der Gruppen, die infolge der Durchführung einer TPA durch Thiol-En-Addition verbrückte und/oder polymerisierte Strukturen aufweisen, über ein Kohlenstoffatom an das Metall/Halbmetall eines metall- oder halbmetallhaltigen Oligomeren oder Polymeren gebunden ist, wobei der Körper zwei Bereiche aufweist, die strukturell, d.h. bezüglich ihrer Primärstrukturen bzw. Sekundärstrukturen, wie oben definiert, unterschiedlich sind und dabei vorzugsweise unterschiedliche Vernetzungsgrade und/oder unterschiedliche Brechungsindizes und/oder E-Module aufweisen (oder, anders ausgedrückt: eine Schicht oder ein dreidimensionaler Formkörper aus oder mit einem organisch modifizierten Polysiloxan oder einem Derivat davon wird bereitgestellt, dessen Siliciumatome ganz oder teilweise durch andere Metallatome ersetzt sind, wobei der organische Anteil des Polysiloxans oder Derivats davon ein organisches Netzwerk mit über Kohlenstoff und/oder Sauerstoff an Silicium und/oder andere Metallatome gebundenen Thiol-En-Additionsprodukten, die über eine 2- oder Mehrphotonenpolymerisationsreaktion erhältlich sind, aufweist, wobei der Körper zwei Bereiche mit unterschiedlichen Primär- und/oder Sekundärstrukturen aufweist,) erhältlich durch das folgende Verfahren:
a) Bereitstellen eines Substrats oder einer Form,
b) Aufbringen eines Materials, das organische, über Zwei- oder Mehrphotonenpolymerisation polymerisierbare Reste enthält, wobei zumindest ein Teil der Gruppen, die über eine TPA Polymere bilden können, über ein Kohlenstoffatom an das Metall/Halbmetall eines metall- oder halbmetallhaltigen Oligomeren oder Polymeren gebunden ist, auf das Substrat bzw. Einfüllen desselben in die Form,
c) selektives Belichten eines ausgewählten Bereichs von auf dem Substrat bzw. in der Form befindlichem Material mit Hilfe von Zwei- oder Mehr-Photonen-Polymerisation,
d) thermisches oder photochemisches Bearbeiten des gesamten auf dem Substrat bzw. in der Form befindlichen Materials,
wobei die Abfolge der Schritte c) und d) beliebig gewählt werden kann.

In einer Reihe von Ausführungsformen ist es dabei bevorzugt, das gesamte Material gemäß Schritt d) zu härten, nachdem die selektive Belichtung stattgefunden hat.

Als erfindungsgemäß einsetzbares Material, das mit Hilfe der Zwei- oder MehrphotonenPolymerisation einer Thiol-En-Addition zugänglich ist, wobei zumindest ein Teil der Gruppen, die infolge der Durchführung einer TPA oder MPA durch Thiol-En-Addition verbrückbar sind und/oder hierdurch polymerisierbare Strukturen aufweisen, über ein Kohlenstoffatom an das Metall/Halbmetall eines metall- oder halbmetallhaltigen Oligomeren oder Polymeren gebunden ist, eignen sich Materialien, die freie SH-Gruppen und isolierte C=C-Doppelbindungen aufweisen. Diese können vorzugsweise drei grundlegenden Materialklassen entnommen werden. Diese Materialien können wie folgt charakterisiert werden:
1. Eine Mischung aus (a) einem organisch modifizierten, polysiloxanhaltigen Material, das über ein Kohlenstoffatom an Silicium gebundene organische Gruppen aufweist, die mit einer oder mehreren SH-Gruppen substituiert sind, und (b) einem rein organischen Material, (einer solchen monomeren, gegebenenfalls statt dessen/zusätzlich oligomeren und/oder polymeren Verbindung), das zwei oder mehrere isolierte C=C-Doppelbindungen aufweist,
2. eine Mischung aus (a) einem organisch modifizierten, polysiloxanhaltigen Material, das über ein Kohlenstoffatom an Silicium gebundene organische Gruppen aufweist, die eine oder mehrere isolierte C=C-Doppelbindungen besitzen, und (b) einem rein organischen Material (einer solchen monomeren, gegebenenfalls statt dessen/zusätzlich oligomeren und/oder polymeren Verbindung), das mit zwei oder mehreren SH-Gruppen substituiert ist, und
3. eine Mischung aus (a) einem organisch modifizierten, polysiloxanhaltigen Material, das über ein Kohlenstoffatom an Silicium gebundene organische Gruppen aufweist, die mit einer oder mehreren SH-Gruppen substituiert sind, und (b) einem organisch modifizierten, polysiloxanhaltigen Material, das über ein Kohlenstoffatom an Silicium gebundene organische Gruppen aufweist, die eine oder mehrere isolierte C=C-Doppelbindungen besitzen.

In allen Fällen kann das Material, das über ein Kohlenstoffatom an Silicium gebundene organische Gruppen aufweist, ein bereits vorkondensiertes Material sein, beispielsweise ein Kieselsäure(hetero)polykondensat, wobei der Ausdruck "hetero" dafür steht, dass ein Teil der Siliciumatome durch andere Metallatome ersetzt ist, wie aus dem Stand der Technik bekannt. In allen Fällen kann das Material, das über ein Kohlenstoffatom an Silicium gebundene organische Gruppen aufweist, und/oder das rein organische Material, sofern vorhanden, weitere reaktive Gruppen aufweisen, beispielsweise Epoxygruppen. Unter den Bedingungen der TPA werden diese Gruppen ebenfalls polymerisiert, was die Vernetzungsdichte über weitere organische Brückenbildung weiter erhöht.

Die erfindungsgemäß einsetzbaren Polysiloxane bzw. Kieselsäure(hetero)polykondensate können solche sein, die aus dem Stand der Technik bekannt sind. So sind in WO 2007/002270 A1 Thiosilane offenbart, und aus WO 2007/002272 A1 sind Norbornensilane bekannt, die unter anderem mit Thiosilanen umgesetzt werden können, wobei ein organisches Netzwerk aufgebaut wird. Diese Norbornensilane sowie andere, ebenfalls isolierte C=C-Bindungen enthaltende Silane lassen sich durch die folgende Formel (I) darstellen

R¹ₐR²_{b}SiX_{4-a-b} (I)

worin R¹ gleich oder verschieden ist und einen eine isolierte C=C-Doppelbindung aufweisenden Rest darstellt, R² gleich oder verschieden ist und einen organischen, keine derartige C=C-Bindung aufweisenden Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind. Als Reste R¹ eignen sich neben Vinyl- oder Allylresten insbesondere Reste, die eine α,β-ungesättigte Carbonylverbindung aufweisen, sowie doppelbindungshaltige Ring- und insbesondere kondensierte Ringsysteme wie der Norbornenyl-Rest und Derivate davon, die beispielsweise eine der folgenden Strukturen aufweisen:

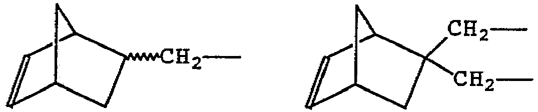

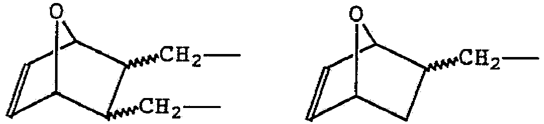

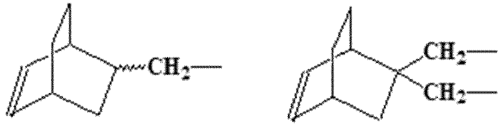

Die bei einem Zusammengeben eines oder mehrerer solcher Silane oder (durch hydrolytische Kondensation daraus entstandener) Kieselsäure(hetero)polykondensate mit Thiolen bzw. Thiosilanen (wobei im letzteren Fall eine hydrolytische Kondensation beider Komponenten gemeinsam nach dem Zusammengeben erfolgen kann) stattfindende Polyaddition (Thiol-en-Addition) führt zur Ausbildung organischer Brücken zwischen Resten R¹ und der thiolhaltigen Verbindung. Wenn das Thiol ein Thiosilan ist, bilden sich zusätzlich zu dem anorganischen Netzwerk des Kieselsäure(hetero)polykondensats organische Brücken, die das gesamte Netzwerk engermaschig werden lassen. Vergleichbares gilt, wenn das Thiol ein Dithiol oder ein höherwertiges Thiol ist, denn dieses verbindet (mindestens) zwei Reste R¹ über eine organische Brücke.

In einer anderen Ausführungsform der Erfindung wird ein organisch modifiziertes polysiloxanhaltiges Material eingesetzt, das durch Hydrolyse und mindestens teilweise Kondensation eines Ausgangsmaterials erhältlich ist, welches mindestens ein Silan der Formel (I')

R³ₐR²_{b}SiX_{4-a-b} (I')

worin R³ gleich oder verschieden ist und einen organischen, über Zwei- oder Mehrphotonenpolymerisation polyaddierbaren Rest darstellt, der mindestens eine SH-Gruppe trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Silan der Formel (I) wie oben angegeben oder eine organische, mindestens zwei isolierte C=C-Doppelbindung enthaltende Verbindung umfasst oder daraus besteht.

Weitere Kieselsäure(hetero)polykondensate, die bei Zusatz eines Thiols einer Thiol-en-Addition zugänglich sind, sind beispielsweise in WO 2013/053693 A1 offenbart. Auch findet sich bereits in DE 4011044 C2 der Hinweis, dass Trimethylolpropantriacrylat (TMPTA) oder Dipentaerythritpentacrylat mit einem Mercaptoalkylalkyldialkoxysilan oder einem Mercaptoalkyltrialkoxysilan zur Reaktion gebracht werden können.

Zusätzlich zu einem Silan der Formel (I) können z.B. Sole oder Gele eingesetzt werden, die durch die folgenden Schritte erhalten wurden: (a) Lösen mindestens einer Verbindung eines oder mehrerer Metalle, ausgewählt unter Magnesium, Strontium, Barium, Aluminium, Gallium, Indium, Silicium, Zinn, Blei und den Übergangsmetallen, in einem organischen Lösungsmittel und/oder Austauschen eines Liganden der bzw. einer der gelösten Metallverbindung(en) gegen einen stabilisierenden Liganden, (b) Zusetzen eines Liganden zu der Lösung, der mindestens eine photochemisch polymerisierbare bzw. addierbare Gruppe und mindestens eine solche Gruppe aufweist, die eine stabile Komplexbildung mit dem jeweiligen Metallatom ermöglicht, und Ausbilden eines Sols mit oder aus dem Produkt dieser Reaktion (Precursor), wobei die photochemisch polymerisierbare Gruppe dieselbe Bedeutung hat wie der Rest R¹ im Silan der oben angegebenen Formel (I). Derartige Sole sind in WO 2011/147854 A1 offenbart.

Beispiele für erfindungsgemäß einsetzbare Thiosilane sind:
3-Mercaptopropyl-trimethoxysilan
3-Mercaptopropyl-triethoxysilan
3-Mercaptopropyl-methyldimethoxysilan.

Als Beispiele für erfindungsgemäß einsetzbare, rein organische Thiol-Verbindungen seien genannt:
Trimethylolpropantri(3-mercaptopropionat) (TMPMP)
Trimethylolpropantrimercaptoacetat (TMPMA)
Pentaerylthritoltetra(3-mercaptopropionat) (PETMA)
Pentaerythritoltetramercaptoacetat (PETMA)
Glykoldimercaptoacetat
Glykoldi(3-mercaptopropionat)
Ethoxyliertes Trimethylolpropantri(3-mercaptopropionat)
4,4'-Thiobisbenzenthiol
4,4'-Dimercaptostilben.

Die erfindungsgemäß einsetzbaren, rein organischen, isolierte C=C-Bindungen aufweisende Verbindungen können beispielsweise (Meth)Acrylgruppen, stärker bevorzugt Methacrylgruppen, insbesondere Acrylat- und/oder Methacrylatgruppen aufweisen, wobei die Methacrylatgruppen dann teilweise Photoinitiator-induziert mit weiteren am Polysiloxan vorhandenen, organisch polymerisierbaren C=C-Doppelbindungen, teilweise unabhängig vom Vorhandensein eines Photoinitiators mit den vorhandenen Thiolgruppen reagieren können.

Die Herstellung von organisch modifizierten Polysiloxanen oder Kieselsäurekondensaten (häufig auch als "Silanharze" bezeichnet) und deren Eigenschaften ist in einer Fülle von Publikationen beschrieben worden. Stellvertretend sei hier z.B. auf Hybrid Organic-Inorganic Materials, MRS Bulletin 26(5), 364ff (2001) verwiesen. Ganz allgemein werden solche Substanzen in der Regel mit Hilfe des sogenannten Sol-Gel-Verfahrens hergestellt, indem hydrolyseempfindliche, monomere oder präkondensierte Silane, ggf. in Gegenwart weiterer cokondensierbarer Substanzen, wie Alkoxiden des Bor, Germanium oder Titan, sowie ggf. von zusätzlichen Verbindungen, die als Modifikatoren oder Netzwerkwandler dienen können, oder von sonstigen Additiven, wie Füllstoffen, einer Hydrolyse und Kondensation unterworfen werden. Materialien, die sich als C=C-doppelbindungshaltige Silane für die vorliegende Erfindung eignen, sind beispielsweise weiterhin in DE 4011044C2, EP 450624 B1, EP682033 B1, EP 1159281 B1, EP 1685182 B1, EP 1874847 B1 und EP 1914260 A1 aufgelistet. Diese Materialien zeichnen sich dadurch aus, dass sie über Kohlenstoff an Silicium gebundene Reste besitzen, die eine oder mehrere organisch durch 2PP (TPA) polymerisierbare Gruppen R¹ aufweisen. In den meisten dieser Materialien sind bzw. können Acryl- und Methacrylgruppen vorhanden sein, die dem obigen Rest R¹ entsprechen; alternativ sind z.B. Norbornenyle sowie Homologe dazu oder andere kondensierte doppelbindungshaltige Systeme, wie Vinyl-, Allyl- oder Styrylgruppen, als Rest R¹ geeignet. Bezüglich einsetzbarer Norbornenylsilane und verwandter Verbindungen kann auch auf die bereits oben erwähnte DE 196 27 198 A1 verwiesen werden. So kann u.a. der Norbornenring selbstverständlich ggf. substituiert sein; auch kann anstelle des Norbornen-Restes (d.h. des Bicyclo[2.2.1]heptenrestes) ein Bicyclo[2.2.2]octen-Rest vorhanden sein. Weiterhin kann der doppelbindungshaltige Fünfring des kondensierten Systems ein Sauerstoffatom enthalten, wenn die (Meth)Acrylgruppe mit Furan anstelle von Cyclopentadien umgesetzt wird.

Die obige Liste ist jedoch nicht als abschließend zu verstehen, was sich auch den nachstehenden Erläuterungen entnehmen lässt.

Neben einem Silan der Formel (I) und/oder der Formel (I') können erfindungsgemäß zusätzliche Silane eingesetzt werden. Eine bevorzugte Kombination nutzt die beiden Silane Ar₂Si(OH)₂ und R¹Si(OR')₃, worin Ar ein aromatischer Rest mit 6 bis 20 Kohlenstoffen, insbesondere ggf. substituiertes Aryl und ganz besonders bevorzugt ein direkt an das Silicium gebundener, unsubstituierter Phenylrest ist und R¹ die für Formel (I) angegebene Bedeutung besitzt und vorzugsweise mindestens eine C=C-Doppelbindung, insbesondere eine einer Michaeladdition zugängliche Doppelbindung, aufweist (z.B. eine (Meth-)Acrylatgruppe ist). Ganz besonders bevorzugt ist R¹ in dieser Kombination eine Methacryloxyalkyl, z.B. eine Methacryloxypropylgruppe. Auch Co-Kondensationsprodukte, in denen Ar₂ und/oder R¹ Styrylgruppen darstellen, sind möglich. Die Herstellung eines Silankondensates aus einer Mischung von Diphenylsilandiol und 3-Methacryloxypropyltrimethoxysilan im Molverhältnis 1:1 ist in DE 199 32 629 A1 in Beispiel 1 beschrieben; das gewählte Verhältnis führt dazu, dass die Hydrolyse durch Einsatz ausschließlich katalytischer Mengen an Wasser erfolgt. Erfindungsgemäß können die hierfür eingesetzten Ausgangsmaterialien mit einem Thiosilan oder einem Di- oder höheren organischen Thiol verwendet werden. So lassen sich Materialien herstellen, die aufgrund des Fehlens von Schwingungen der OH-Gruppe im Telekommunikationsbereich bei 1310 und 1550 nm eine niedrige Absorption aufweisen.

Bevorzugt enthält der Rest R¹ in Formel (I) oben eine oder mehrere einer Michael-Addition zugängliche Doppelbindungen, z.B. α,β-ungesättigte Carbonylverbindungen. Dies können Acryl- oder Methacrylgruppen sein, insbesondere in Form der (Meth)Acrylate, (Meth)Acrylamide und (Meth)Acrylthioester. R² kann eine ggf. substituierte Alkyl-, Aryl-, Alkylaryl- oder Arylalkylgruppe sein, wobei die Kohlenstoffkette dieser Reste ggf. durch O, S, NH, CONH, COO, NHCOO oder dgl. unterbrochen sein kann. R² kann dabei auch Gruppen enthalten, die mit C=C-Doppelbindungen eine Additionsreaktion eingehen können, oder eine für biologische Zwecke relevante Gruppe enthalten, wie aus WO 2011/98460 A1 bekannt. Die Gruppe X ist in der Regel Wasserstoff, Halogen, Alkoxy, Acyloxy oder NR⁵₂ mit R⁵ gleich Wasserstoff oder Niederalkyl. Alkoxygruppen sind als abhydrolysierbare Gruppen bevorzugt, insbesondere Niederalkoxygruppen wie C₁-C₆-Alkoxy.

Das verfestigbare Organopolysiloxan kann unter Verwendung mindestens eines weiteren Silans der Formel (II)

SiX₄ (II)

erzeugt worden sein, worin X gleich oder verschieden ist und die gleiche Bedeutung wie in Formel (I) besitzt. Eine hierfür gut einsetzbare Verbindung ist Tetraethoxysilan. Durch Zugabe solcher Silane zu der zu hydrolysierenden und kondensierenden Mischung, aus der schließlich das polymerisierbare Badmaterial entsteht, wird der SiO-Anteil des Harzes, also der anorganische Anteil, erhöht. Dadurch lässt sich die Absorption des Harzes in den interessierenden Wellenlängen senken.

Umgekehrt kann das erfindungsgemäß organisch zu polymerisierende Silanpolykondensat unter Verwendung mindestens eines Silans mit der Formel (IV)

R¹ₐSiR²₄₋ₐ (IV)

hergestellt worden sein, worin R¹ und R² die oben für Formel (I) angegebene Bedeutung haben. Dadurch wird der Vernetzungsgrad des Polykondensates heruntergesetzt.

Außerdem kann R¹ ein von R¹ der Formel (I) verschiedener organischer, über Zwei- oder Mehrphotonenpolymerisation polymerisierbarer Rest sein.

Die Mischung, aus der das Silankondensat erzeugt wird, kann weiterhin mindestens ein Silanol der Formel (III)

R⁴ₐSi(OH)₄₋ₐ (III)

enthalten, worin R⁴ gleich oder verschieden sein kann und jeweils entweder die Bedeutung von R¹ wie in Formel (I) definiert oder von R² wie in Formel (I) definiert besitzt und worin der Index a 1, 2 oder 3, vorzugsweise 2 bedeutet. Die Hydrolyse kann in Gegenwart dieser Verbindungen daher mit Hilfe von katalytisch wirksamen Mengen von Wasser erfolgen; im Übrigen kann das System wasserfrei bleiben. In einer bevorzugten Ausgestaltung der Erfindung werden Disilanole der Formel (III) im Mischungsverhältnis von 1:1 (Mol/Mol) mit Silanen der Formel (I), die vorzugsweise eine Gruppe R¹ enthalten, als zu hydrolysierendes und kondensierendes Ausgangsmaterial eingesetzt.

Wenn R² in Formel (I) nicht vorhanden ist oder keine funktionellen Gruppen besitzt, kann in einer spezifischen Ausgestaltung dem zu hydrolysierenden und kondensierenden Material mindestens ein Silan der Formel (V)

R³ₐSiX₄₋ₐ (V)

zugegeben werden, worin R³ eine Gruppe trägt, die radikalisch an eine C=C-Doppelbindung addiert werden kann, insbesondere eine Thiolgruppe. Entsprechende Kondensate sind dann einer Polymerisation durch Additionsreaktionen der Gruppen R³ der Silane der Formel (V) an Doppelbindungen der Reste R¹ der Silane mit der Formel (I) zugänglich.

Die für die Zwecke der vorliegenden Erfindung zu hydrolysierende und kondensierende Mischung kann weitere Substanzen enthalten, z.B. vorzugsweise niedere Alkoxide, insbesondere C₁-C₆-Alkoxide, von Metallen der III. Hauptgruppe, von Germanium und von Metallen der II., III., IV., V., VI., VII. und VIII. Nebengruppe.

Insgesamt sollte das organisch modifizierte Kieselsäurepolykondensat, aus dem sich die erfindungsgemäßen Körper herstellen lassen, vorzugsweise mindestens 0,1 Mol an einer Zwei- oder Mehrphotonenpolymerisation zugänglichen Gruppen (R¹ der Formel (I)) aufweisen, bezogen auf die Molmenge an Siliciumatomen plus ggf., soweit vorhanden, der Metallatome der III. Hauptgruppe, von Germanium und der II., III., IV., V., VI., VII. und VIII. Nebengruppe.

In einer alle vorgenannten Ausgestaltungen umfassenden bevorzugten Ausführungsform der Erfindung enthält das Material, das auf dem genannten Substrat bzw. in der genannten Form verfestigt wird, mindestens ein Silan mit mindestens einem Rest R¹ oder mindestens einem Rest R³ wie oben angegeben und zusätzlich ein rein organisches, der Zwei- oder Mehrphotonenpolymerisation zugängliches Monomer oder Oligomer oder Polymer, wobei diese rein organische Verbindung derselben zwei- oder Mehr-Photonenpolymerisationsreaktion zugänglich ist wie die Reste R¹ bzw. R³ an den (vorkondensierten) Silanen der Formel (I). In einer bevorzugten Ausführungsform handelt es sich dabei um dieselben Reste R¹. In einer stärker bevorzugten Ausführungsform sind die organischen Monomere ausgewählt unter Monomeren, mit deren Hilfe die Silane der Formel (I) bzw. (I') erzeugt wurden. Besonders günstig sind hier Acryl- und Methacrylverbindungen, wie die (Meth)Acrylate.

In einer alternativen Ausführungsform können die monomeren organisch polymerisierbaren Verbindungen jedoch auch andere Verbindungen sein als die für die Herstellung der Silane verwendeten. Dabei können solche Monomere ausgewählt werden, die sich mit Resten R¹ des Siloxans photochemisch copolymerisieren lassen. Diese reagieren unter Bestrahlung teils mit sich selbst, teils mit den organisch polymerisierbaren Gruppen des Polysiloxans. Als Beispiele seien hier genannt:
1,12-Dodecandioldimethacrylat (DDDMA)
Tetramethylenglykoldimethacrylat (TGMDMA)
Triethylenglycoldimethacrylat (TEGDMA)
Ethylmethacrylat (EMA)
Tridecylmethacrylat (C13MA)
Varianten von Polyethylenglycolmethylether-methacrylat (MPEG500MA)
Bisphenol-A-Ethoxydiacrylat (BED)
Polyethylenglycol-Dimethacrylat (PEG400DMA)
Triethylenglykoltriacrylat
Trimethylolpropantriacrylat (TMPTA)

Die Auswahl dieser Monomeren erfolgt unter Berücksichtigung der Tatsache, dass sie in einem Molekül unterschiedliche Polaritäten, eine unterschiedliche Anzahl an polymerisierbaren Gruppen, insbesondere Methacryl- oder Acrylgruppen, und, bei mehr als einer polymerisierbaren Gruppe, unterschiedliche Kettenlängen zwischen zwei polymerisierbaren Gruppen aufweisen. Wenn Monomere mit mehr als einer polymerisierbaren Gruppe gewählt werden, entstehen dichtere organisch verknüpfte Netzwerke. Mit der Kettenlänge lassen sich mechanische Eigenschaften, wie Elastizität oder E-Modul und dergleichen, einstellen.

Die Menge an monomeren organisch polymerisierbaren Verbindungen ist nicht kritisch, in bevorzugter Weise liegt sie im Bereich von bis zu 0,5 Mol, stärker bevorzugt im Bereich von 0,1 bis 0,3 Mol pro für das Siloxan eingesetztem Mol Silan der Formel (I).

Das organisch modifizierte, polysiloxanhaltige Material enthält weiterhin zumindest dann, wenn die Polymerisation nicht ausschließlich über eine Thiol-En-Addition erfolgt, einen Photoinitiator. Das kann beispielsweise ein Initiator aus der Irgacure-Familie sein, wie Irgacure 369, Oxe01 oder Oxe02, oder ein anderer Initiator, wie Lucirin TPO und -TPO-L. Insbesondere ist auch auf die speziell für die Zwei- und Mehrphotonenpolymerisation entwickelten Initiatoren zu verweisen, die durch Wasserstoffabstraktion wirken, z.B. Irgacure 369, DPD oder N-DPD (1,5-Diphenyl-penta-1,4-diyn-3-on bzw. das ortho-Dimethylaminoderivat davon), siehe z.B. R. Liska et al. in Applied Surface Science 254, 836-840 (2007) und B. Seidl et al. in Macromol. Chem. Phys. 208, 44-54 (2007). Kationische Initiatoren können zusätzlich eingesetzt werden, wenn das polysiloxanhaltige Material beispielsweise zusätzlich Epoxidgruppen enthält. Damit lässt sich eine noch genauere Steuerung der Polymerisation bewirken.

Der Photoinitiator wird vorzugsweise zugegeben, nachdem die anorganische Vernetzung des Materials durch hydrolytische Kondensation des oder der eingesetzten Silane bereits stattgefunden hat. Hierfür wird er eingewogen und unter Rühren in Gelblicht (Reinraumbedingungen, Gelblichtlabor) in die Materialformulierung eingebracht. Danach ist das Material einsatzbereit, kann aber auch noch, falls gewünscht, filtriert werden.

Die Menge an zuzusetzendem Photoinitiator ist nicht kritisch, sie kann z.B. in einem Bereich zwischen 0,1 und 5 Gew.-% liegen. Günstig sind häufig 2 Gew.-%. Wenn das System nichtaktivierbare Doppelbindungen aufweist, beispielsweise in Form von Norbornenylgruppen, kann die Menge an Initiator jedoch deutlich niedriger gewählt werden. Gegebenenfalls kann der Photoinitator sogar weggelassen werden, nämlich dann, wenn ausschließlich Thiol-En-Verknüpfungen gebildet werden sollen, z.B. bei Umsetzung eines norbornenhaltigen Polysiloxans mit einem monomeren Thiol.

Um die Funktionalität des dreidimensionalen Formkörpers mit Bereichen unterschiedlicher Vernetzungsstruktur herzustellen, muss das Material belichtet werden. Hierfür wird dieses auf ein Substrat auf- oder in eine Form eingebracht, wobei es in der Form ein Bad bilden kann. Dies kann durch beliebige, im Stand der Technik bekannte Verfahren erfolgen, beispielsweise Aufschleudern, Rakeln, Dispensieren, Drucken, Tauchen oder Sprühen eines flüssigen oder pastösen Materials, aber auch durch Auflegen und ggf. Befestigen eines bereits verfestigten Materials auf bzw. am Substrat oder in die bzw. in der Form, wobei alle gängigen Substrat- und Form-Materialien verwendet werden können, wie Glas, Silizium, Metalle, und die Schichtdicke völlig variabel, beispielsweise zwischen 100 nm und mehreren mm, gewählt werden kann. Das Substrat kann planar sein, statt dessen aber auch eine unebene Form besitzen; es lassen sich Formkörper beliebiger, auch größerer Abmessung, insbesondere einer relativ großen Höhe fertigen, z.B. im Bereich von 1-10 mm.

Danach wird der Formkörper durch ein Verfahren hergestellt, das mindestens zwei Schritte umfasst. In einem davon wird das flüssige bzw. pastöse oder auch feste Material mit Hilfe eines Lasers, vorzugsweise eines Ultrakurzpulslasers, selektiv an den im Voraus berechneten, gewünschten Stellen verfestigt, an denen die Strukturänderung im fertigen Produkt gewünscht ist, z.B. an denjenigen Orten, die im fertigen Produkt einen höheren Brechungsindex aufweisen sollen. Hierfür wird ein Laserstrahl auf jedes zu verfestigende Volumenelement gerichtet. Geeignet ist hierfür insbesondere eine Bestrahlung mit Femtosekunden-Laserpulsen. Als Strahlquelle können grundsätzlich Festkörperlaser, Dioden-gepumpte Festkörperlaser, Halbleiterlaser, Faserlaser, etc. beliebiger Wellenlänge verwendet werden. Mit besonderem Vorteil wird in einer Ausführungsform der Erfindung ein Ytterbium-Lasersystem verwendet. Dessen Wellenlänge befindet sich bei Frequenzverdopplung im Bereich von grünem Licht. Vorteil von Ytterbium Lasern gegenüber Ti-Saphir-Lasersystemen, die eine Wellenlänge von ca. 800nm besitzen (wobei jedoch auch die zweite Harmonische bei 400 nm genutzt werden kann), ist die Wellenlänge von 1030 nm. Diese liegt bei Frequenzverdoppelung im grünen Bereich bei 515 nm, was zu einer verbesserten Auflösung führen kann. Außerdem können die zu strukturierenden Materialien effizienter bearbeitet werden als mit Lasern in Wellenlängenbereichen von ca. 800 nm. Das Prozessfenster ist hinsichtlich Materialformulierungen deutlich größer. Der Vorteil von Ytterbium-Lasersystemen liegt darin, dass man diese Laser mit Dioden pumpen kann und keinen zusätzlichen Pumplaser und diverse andere Instrumente notwendig sind. Der Vorteil von Ytterbium-Lasern gegenüber Nd:YAG-Lasern sind relativ kurze Pulse. Auch andere Kurzpulslaser können im erfindungsgemäßen Verfahren eingesetzt werden, insbesondere Faserlaser. Bei Verwendung größerer Wellenlängen kann die Polymerisation auch durch eine n-Photonenabsorption initialisiert werden, wobei n größer 2 gilt. Die Schwellen-Fluenz, bei welcher der Polymerisationsprozess startet, kann durch die Wahl geeigneter Komponenten, wie z.B. CoInitiatoren und/oder Aminkomponenten, mit einem erhöhten Mehrphotonen-Absorptionsquerschnitt im Harz gesenkt werden. Dadurch wird das Prozessfenster, in dem die Polymerisation stattfindet, das Material jedoch noch nicht zerstört wird, vergrößert. Selbstverständlich muss das auszuhärtende Material transparent für die verwendete Laserwellenlänge sein.

Die Form und Gestalt des selektiven Bereichs kann frei gewählt werden. In manchen Fällen ist es günstig, einen Basispunkt am Substrat bzw. an der Form zu wählen, von dem ausgehend sich die sich verfestigende Struktur erstreckt. Dies ist jedoch keine notwendige Maßnahme, vielmehr kann die Struktur frei in das Material geschrieben werden, und zwar überraschenderweise auch dann, wenn dieses zuvor auf welche Weise auch immer in einen bereits festen Zustand überführt wurde. Es können beispielsweise Strukturen erzeugt werden, die sich als Wellenleiter eignen.

In einem vorangehenden oder, bevorzugt, nachfolgenden Schritt wird in der bevorzugten, aber nicht einzig möglichen Ausführungsvariante der Erfindung das gesamte auf dem Substrat bzw. in der Form befindliche Material verfestigt. Dies kann entweder durch Bestrahlung oder durch Erwärmen erfolgen. Wird in diesem Schritt eine Bestrahlung verwendet, erfolgt sie vorzugsweise mit UV-Licht, z.B. im Bereich zwischen 200 und 500 nm, ganz besonders bevorzugt bei etwa 365 nm (sogenannte I Linie), also mit einer in etwa doppelten Energie der einfallenden Photonen, verglichen mit der Belichtung während der Zwei-Photonen-Polymerisation. Eine thermische Verfestigung erfolgt vorzugsweise bei Temperaturen im Bereich zwischen 80 und 170°C, wobei der Zeitraum vom Fachmann je nach Größe der Form in geeigneter Weise gewählt werden, kann und z.B. einige Sekunden bis zu mehreren Stunden beträgt. In einer speziellen Ausführungsform können die beiden Maßnahmen kombiniert werden, wobei der Bestrahlung mit UV-Licht die thermische Nachhärtung folgt. Diese Vor- oder Nachbehandlung dient der vollständigen Aushärtung, so dass sichergestellt ist, dass das entstandene Produkt auch über große Zeitspannen hinweg hinsichtlich der optischen und mechanischen Eigenschaften stabil bleibt. Die Brechzahl-Differenz Δn wird hierbei zwar wiederum kleiner, überraschenderweise bleibt sie aber in ausreichendem Maße bestehen und wird nicht aufgehoben, obwohl man aufgrund der Sättigungskurven der TPA-Reaktion davon ausgehen muss, dass in beiden Bereichen alle organisch polymerisierbaren Gruppen, soweit nicht sterisch daran gehindert, vollständig umgesetzt sein sollten.

In allen vorgenannten Ausführungsformen ist es dabei möglich, dass dem Schritt des selektiven Verfestigens ein Vorvernetzungs-Schritt vorangeht. Dies hat den Vorteil, dass das selektive Belichten zur Erzeugung der Bereiche mit z.B. höherem Brechungsindex zu möglicherweise genaueren Strukturen führt, da Diffusionsprozesse und Bewegungsprozesse im Material abgeschwächt oder verhindert sind, die beispielsweise durch den punktuellen Energieeintrag und/oder, falls die Probe bewegt wird und nicht nur der Laser, die Bewegung der Probe während des Belichtungsvorgangs verursacht werden. Völlig überraschend konnten die Erfinder feststellen, dass eine solche Vorhärtung die nachfolgende selektive Erzeugung der gewünschten Strukturen nicht behindert oder verschlechtert. Dabei ist es bevorzugt, die Vorvernetzung auf photochemischem Wege durch Bestrahlung zu bewirken. Die Bestrahlung kann bei denselben Wellenlängen erfolgen wie vorstehend beschrieben; die Dauer liegt bei unter einer Sekunde bis zu ca. 60 Minuten, wobei insbesondere eine Dauer von 1 bis 360 s, hier wiederum insbesondere 5 bis 60 s, günstig ist. Dass dieser Schritt die nachfolgende selektive Vernetzung von mit 2-Photonen-Polymerisation behandelten Bereichen nicht negativ beeinflusst, ist völlig überraschend, wenn man bedenkt, dass die Materialien bereits nach 1 bis 30 s vollständig (d.h. bis zur "Sättigung") vernetzt sind, wie Erfinder seit Jahren aus ihren spektroskopischen Untersuchungen wissen.

Konkret lassen sich mit den vorgenannten Maßnahmen insbesondere fünf definierte Verfahren beschreiben, wie folgt:
Ganz allgemein gilt: Wenn das eingesetzte Ausgangsmaterial flüssig oder pastös ist, wird es auf ein Substrat auf- oder in eine Form oder ein Bad eingebracht. In alternativen Ausführungsformen ist das Ausgangsmaterial bereits fest (manche Polysiloxane, z.B. Styrylgruppen enthaltende, sind nach der vollständigen hydrolytischen Kondensation bereits fest oder halbfest). Im ersteren Falle kann das Auf- oder Einbringen durch beliebige, im Stand der Technik bekannte Verfahren erfolgen, beispielsweise Aufschleudern, Rakeln, Dispensen, Drucken, Tauchen oder Sprühen eines flüssigen oder pastösen Materials, aber auch durch Auflegen und ggf. Befestigen eines bereits verfestigten Materials auf bzw. am Substrat oder in die bzw. in der Form, wobei alle gängigen Substrat- und Form-Materialien verwendet werden können, wie Glas, Silizium, Metalle, und die Schichtdicke völlig variabel gewählt werden kann, beispielsweise zwischen 100 nm und mehreren mm. Das Substrat kann planar sein, statt dessen aber auch eine unebene Form besitzen; es lassen sich Formkörper beliebiger, auch größerer Abmessung, insbesondere einer relativ großen Höhe fertigen, z.B. im Bereich von 1-10 mm.

### Verfahren 1

Im ersten Schritt wird in dem auf dem Substrat/in der Form befindlichen Material mittels einer geeigneten Optik ein ultrakurz gepulster Laserlicht-Fokus erzeugt. Im Laserfokus wird eine Zwei-Photonen-Polymerisation des dort befindlichen Ausgangsmaterials bewirkt. Der Fokus wird so durch das Material bewegt, dass infolge der Zwei- oder Mehr-Photonen-Polymerisation die gewünschten Volumenelemente darin optisch polymerisiert werden, während das umgebende/angrenzende Badmaterial unverändert bleibt ("Laserschreiben"). Nach Fertigstellen des gewünschten Bereichs mit TPA- oder MPA-Vernetzung wird in einem zweiten Schritt das gesamte Bad mit UV-Licht belichtet, vorzugsweise mit einer Wellenlänge von 200-500 nm und besonders bevorzugt von 365 nm (I-Linie).

### Verfahren 2

Dieses Verfahren umfasst die beiden Schritte des Verfahrens 1. Daran schließt sich ein dritter Schritt an, bei dem das gesamte Badmaterial thermischer Energie ausgesetzt wird, beispielsweise in einem Ofen oder durch das Stellen der badgefüllten Form auf eine heiße Platte. Die Dauer dieser Maßnahme wird je nach Bedarf gewählt, sie liegt bei wenigen (z.B. 5) Minuten bis zu einigen (z.B. 8) Stunden. Das Material kann dabei auf Temperaturen von insbesondere zwischen 80 und 170°C aufgeheizt werden. Höhere Temperaturen sind jedoch nicht auszuschließen.

### Verfahren 3

Das eingesetzte Ausgangsmaterial wird in einem ersten Schritt vollständig mit Licht bestrahlt, vorzugsweise mit UV-Licht einer Wellenlänge von 200-500 nm, ganz besonders bevorzugt von 365 nm (I. Linie). Die Dauer der Bestrahlung ist überraschenderweise nicht kritisch; sie kann z.B. zwischen 1 und 3600 s liegen, d.h. bis über die Sättigung der TPA-Reaktion hinaus. Noch längere Belichtungszeiten sind nicht ausgeschlossen. Der zweite und der dritte Schritt entsprechen dem ersten und dem zweiten Verfahrensschritt des Verfahrens 1.

### Verfahren 4

Der erste Verfahrensschritt entspricht dem ersten Verfahrensschritt des Verfahrens 3. Der zweite und der dritte Schritt entsprechen dem zweiten (2-PP/M-PP) und dem dritten Verfahrensschritt (thermische Nachhärtung) des Verfahrens 2.

### Verfahren 5

Gemäß diesem Verfahren wird in einem ersten Schritt das eingesetzt Ausgangsmaterial vollständig mit Licht bestrahlt, wie für Verfahren 3 beschrieben. Daran schließt sich der Schritt des "Laserschreibens" an, wie für Verfahren 1 beschrieben. Von Verfahren 3 unterscheidet sich Verfahren 5 dadurch, dass auf eine nachträgliche Verfestigung verzichtet wird.

In allen vorgenannten Varianten kann zusätzlich mechanischer Druck aufgebracht werden, der je nach dem Anwendungszweck gewählt wird. Hierfür kann beispielsweise von oben ein planares Substrat auf die Oberfläche der dem Verfahren unterworfenen Schicht bzw. der des Formkörpers aufgebracht und das so erhaltene "Sandwich" in eine Presse gegeben werden. Organisch durch Zwei- oder Mehr-Photonenpolymerisation (2-PP, M-PP) vernetzte Organopolysiloxane, deren organisch vernetzte Gruppen Bestandteile von über Kohlenstoff an Silicium gebundenen Resten sind, sind bevorzugt duroplastische Materialien, die sich durch eine gute Temperaturbeständigkeit sowie eine hervorragende Temperatur-Formbeständigkeit im Vergleich zu den meisten rein organischen Polymeren auszeichnen. Thiol-en-vernetzte Organopolysiloxane besitzen darüber hinaus in der Regel eine einstellbare, häufig hohe Flexibilität, wie sich im 3-Punkt-Biege- und Zugversuch nachweisen lässt, sowie ein breites Spektrum an Zug- und Dehnfestigkeiten. So kann der Zug-E-Modul im Bereich von ca. 1 - 550 MPa und/oder der Biege-E-Modul im Bereich von ca. 6 - 2100 MPa eingestellt und je nach Bedarf eine elastische Dehnung im Zugversuch bis zum Versagen von bis zu 130% erreicht werden, wobei Werte von über 8% sehr häufig erzielbar sind.

In einer zweiten, oben nicht als bevorzugt genannten Ausführungsvariante wird der (einzige) Schritt bzw. werden alle Schritte des Verfestigens des gesamten Materials weggelassen. Man erhält damit durch das "Laserschreiben" erst einmal eine verfestigte Struktur, deren Außenränder zumindest teilweise vom flüssigen oder pastösen Ausgangsmaterial umgeben sind. Dieses Ausgangsmaterial ist aufgrund der fehlenden Vernetzung in vielen Lösungsmitteln löslich, die der Fachmann kennt, beispielsweise in Alkoholen, wässrigen alkoholischen Lösungen, Ketonen oder Mischungen davon, und lässt sich daher in einfacher Weise wegwaschen. Zurück bleibt ein strukturierter Formkörper oder eine strukturierte Oberfläche. Ein derartiges Verfahren eignet sich insbesondere für die Herstellung von Formkörpern oder Oberflächen mit komplizierter Geometrie, die sich mit Hilfe von formenden Verfahren oder mit Maskenbelichtung nur schwer herstellen lassen. Beispiele für derartige Formkörper sind poröse Formkörper, insbesondere mit Poren im µm- oder nm-Bereich, die ggf. eine nicht geradlinige Geometrie aufweisen können. Solche Formkörper werden beispielsweise als Scaffolds (zum Aufwachsenlassen von lebenden Zellen) benötigt.

Eine Reihe von erfindungsgemäß verwendbaren anorganisch vernetzbaren Organopolysiloxanen (Organokieselsäurepolykondensaten) besitzen eine niedrige Absorption im Bereich der für Daten- und Telekommunikation interessierenden Wellenlängen (810 bis 1550 nm). Solche Polymere erhält man beispielsweise, wenn das Kondensat nur noch unbedeutende Anteile an SiOH-Gruppen aufweist oder fast oder ganz frei davon ist. Eine niedrige Absorption erhält man auch z.B. durch Einsatz von Ausgangsmaterialien, deren kohlenstoffhaltige Gruppen ganz oder teilweise fluoriert sind. Weiterhin ist es für diesen Zweck z.B. günstig, den Anteil an SiO-Gruppen im Harz, also den "anorganischen" Anteil, relativ hoch zu halten. Dies gelingt beispielsweise durch Zusatz von Silanen zu der zu hydrolysierenden Mischung, die keine organischen Gruppen enthalten, sondern an allen vier Resten hydrolysiert werden können, z.B. von Tetraalkoxysilanen, wie Tetraethoxysilan. Die im Bereich von 810 bis 1550 nm in den entsprechenden Frequenzbanden wenig lichtabsorbierenden Materialien erlauben es, mit Hilfe des erfindungsgemäßen Verfahrens passive und aktive optische Elemente kostengünstig zu fertigen, deren innere optischen Oberflächen sehr glatt bzw. fein und genau strukturiert sind, wie z.B. Wellenleiter, Prismen, Mikrolinsen oder auch Gitter.

Wie erwähnt, sind Harze auf Organopolysiloxanbasis Materialien, die in einer großen Vielzahl und Vielfalt in Hinblick auf verschiedene physikalische, chemische und biologische Eigenschaften ausgewählt werden können, da sie eine Vielzahl verschiedener funktioneller Gruppen tragen können, welche die physikalischen und chemischen Eigenschaften des Harzes beeinflussen (z.B. Netzwerkbildner, Netzwerkwandler). Daher sind diese Harze für eine Anwendung in den bezeichneten Gebieten von besonderem Vorteil. Dies gilt vor allem für die erfindungsgemäß bevorzugte Nutzung von Femtosekundenlaser-Bestrahlung von Silanharzen.

Die Flexibilität des Verfahrens und der dafür eingesetzten Organopolysiloxane einerseits und ihre Nicht-Toxizität andererseits gestattet ebenfalls eine Anwendung im Bereich der Herstellung beliebig komplizierter, dreidimensionaler Strukturen aus einem virtuellen Modell am Computer.

Nachstehend soll die Erfindung anhand von Ausführungsbeispielen näher erläutert werden. Es wurde bereits deutlich gemacht, dass eine Vielzahl von Polysiloxanen für die Erfindung geeignet ist; da deren Formulierung wiederum aufgrund des Zusatzes einer Vielzahl von Monomeren variiert werden kann, sind die nachfolgenden Beispiele auf ein nur einige ausgewählte Ausgangsmaterialien beschränkt; dem Fachmann sollte klar sein, dass er statt dessen ein beliebiges der Materialien verwenden kann, deren Herstellung z.B. in den oben angegebenen Druckschriften beschrieben ist, und auch diese in analoger Weise variieren kann.

### Materialbeispiele

### Allgemeine Vorschrift für die Messung mechanischer Daten

Das jeweilige Harz wird mit Lucirin TPO in eine Stäbchenform (2 x 2 x 25 mm³) gegeben. Nach dem Aushärten des Stäbchens unter den jeweils angegebenen Vernetzungsbedingungen werden mittels 3-Punktbiegeversuch der Biege-E-Modul und die Durchbiegung bis zum Bruch der resultierenden Stäbchen bestimmt. Mittels Zugversuch wird der Zug-E-Modul und die max. Dehnung der resultierenden Zugproben (an einem knochenförmigen Stäbchen; Messlänge ohne Knochenabschnitte: 21 mm) bestimmt.

### Beispiel 1

### Synthese von Basisharz I (Harz mit identischen C-Si-gebundenen Resten mit einer Methacrylat- und einer Hydroxygruppe, siehe DE 4416857)

Zur Vorlage von 125,0 g (0,503 mol) 3-Glycidyloxypropyltrimethoxysilan werden unter trockener Atmosphäre 1,31g (0,005mol) Triphenylphosphin als Kat., 0,2 Gew.-% BHT als Stabilisator und anschließend 47,35 g (0,550 mol) Methacrylsäure zugetropft und bei 80°C gerührt (ca. 24 h). Die Umsetzung kann über die Abnahme der Carbonsäurekonzentration mittels Säuretitration sowie dem Epoxidumsatz mittels Ramanspektroskopie/Epoxidtitration verfolgt werden. Nach Zugabe von Essigester (1000 ml/mol Silan) und H₂O zur Hydrolyse mit HCl als Kat. wird bei 30°C gerührt. Der Verlauf der Hydrolyse wird jeweils durch Wassertitration verfolgt. Die Aufarbeitung erfolgt nach ca. mehrtägigem Rühren durch mehrmaliges Ausschütteln mit wässriger NaOH und mit Wasser und Filtration über hydrophobierten Filter. Es wird zunächst abrotiert und anschließend mit Ölpumpenvakuum abgezogen. Es resultiert ein flüssiges Harz ohne Einsatz von Reaktivverdünnern (Monomeren) mit einer sehr geringen Viskosität von ca. 3 - 6 Pa·s bei 25°C (stark abhängig von den genauen Hydrolyse- und Aufarbeitungsbedingungen) und 0,00 mmol CO₂H/g (keine freien Carboxylgruppen).

Das Harz wird mit 1% Lucirin TPO versetzt und in eine Stäbchenform (2 x 2 x 25 mm³) gegeben. Die (Meth)acrylatgruppen werden im Rahmen einer photoinduzierten radikalischen Polymerisation umgesetzt, wobei das Harz aushärtet. Mittels 3-Punktbiegeversuch wird nach 1,5 Tagen Lagerung bei 40°C (Härtungsvariante A) der E-Modul des resultierenden Stäbchens bestimmt. Das Ergebnis ist in Tabelle 1 dargestellt.

### Beispiel 2

### Synthese eines Grundharzsystems, ausgehend von Basisharz I (siehe DE 10201105440 A1, Umsetzung mit einer Menge an Cyclopentadien (CP), die für die vollständige Umsetzung der Doppelbindungen ausreicht)

1. Ansatz: Zur Vorlage von 132,2 g (0,50 mol) von Basisharz I werden unter Rühren bei ca. 90°C ca. 72,1 g (1,1 mol) Cyclopentadien (CP) (durch Spaltung von Dicyclopentadien frisch hergestellt, was auch in den nachfolgenden Beispielen der Fall ist) zudestilliert und danach noch ca. 1-2 h bei 90°C weitergerührt. Die Umsetzung kann mittels NMR sowie über die Abnahme der v(C=C, Methacryl)-Bande (1639 cm⁻¹) sowie die Bildung und Zunahme der v(C=C, Norbornenyl-Bande (1574 cm⁻¹) mittels Raman-Spektroskopie verfolgt werden. Die flüchtigen Bestandteile, wie z. B. nicht umgesetztes Cyclopentadien, werden im Ölpumpenvakuum bei Temperaturen bis zu 90°C abgezogen. Es resultiert ein flüssiges Harz mit einer Viskosität von ca. 74-86 Pa·s bei 25°C. Eine weitere Aufarbeitung ist in der Regel nicht erforderlich.
2. Ansatz: Zur Vorlage von 80,0 g (0,30 mol) von Basisharz I werden unter denselben Bedingungen wie im 1. Ansatz ca. 45,5 g (0,69 mol) Cyclopentadien (CP) zudestilliert und danach noch ca. 1 - 2 h bei 90°C weitergerührt. Die Umsetzung kann wie oben erwähnt spektroskopisch verfolgt werden. Die flüchtigen Bestandteile, wie z. B. unumgesetztes Cyclopentadien, werden im Ölpumpenvakuum bei Temperaturen bis zu 90°C abgezogen. Es resultiert ein flüssiges Harz mit einer Viskosität von ca. 53 - 110 Pa·s bei 25°C (stark abhängig von den genauen Synthese- und Aufarbeitungsbedingungen auch der Vorstufen). Eine weitere Aufarbeitung ist in der Regel nicht erforderlich.

Das Harz des 2. Ansatzes wird nach Zusatz des Trithiols TMPMP (Trimethylolpropan-(3-mercapto-propionat) (molares Verhältnis SH : C=C = 1 : 1) und 0,5 % Lucirin TPO (Lichthärtung + 1,5 Tage 40°C = Härtung A bzw. Lichthärtung + 1,5 Tage 80°C = Härtung B) bzw. mit 1,5 mMol DBPO/100 g Harz und 2,4 mMol N,N-Bis-2-hydroxyethyl-p-toluidin/100 g Harz (2K-Härtung bei 40°C = Härtung C bzw. 80°C = Härtung D jeweils bis zur Konstanz der mechanischen Daten) in Stäbchenformen (2 x 2 x 25 mm³ bzw. in eine knochenförmige Stäbchenform mit einem Messlängen-Abschnitt von 21 mm ohne die knochenförmigen Enden) zur Härtung gegeben. Dabei werden die C=C-Doppelbindungen der Norbornengruppen im Rahmen einer photo- bzw. redox-induzierten radikalischen Thiol-En-Polyaddition umgesetzt.

Mittels 3-Punktbiegeversuch wird der E-Modul der resultierenden Stäbchen bestimmt, wobei die Prüfkörper aufgrund der hohen Elastizität auch bei hohem E-Modul nicht brechen. Mittels Zugversuch wird der Zug-E-Modul und die max. Dehnung der resultierenden Zugproben (Messlänge 21 mm) bestimmt. Die Ergebnisse sind in Tabelle 1 dargestellt.

### Beispiel 3

### (Umsetzung des Basisharz I mit einer Menge an CP, die für die vollständige Umsetzung der Doppelbindungen nicht ausreicht; Herstellung eines Norbornen-Methacryl-Mischsystems)

Zur Vorlage von 26,6 g (0,10 mol) von Basisharz I werden unter Rühren bei ca. 90°C ca. 9,94 g (0,15 mol) Cyclopentadien (CP) zudestilliert und danach noch ca. 1,25 h bei 90°C weitergerührt. Die flüchtigen Bestandteile werden im Ölpumpenvakuum bei Temperaturen bis zu 90°C abgezogen. Es resultiert ein flüssiges Harz (ca. 33 Mol-% unumgesetzte Methacrylatgruppen) mit einer Viskosität von ca. 29 Pa·s bei 25°C (stark abhängig von den genauen Synthese- und Aufarbeitungsbedingungen auch der Vorstufen). Eine weitere Aufarbeitung ist in der Regel nicht erforderlich.

Das Harz wird nach Zusatz des Trithiols TMPMP (molares Verhältnis SH : C=C = 1 : 1) und 0,5% Lucirin TPO (Lichthärtung + 1,5 Tage 40°C = Härtung A) in Stäbchenformen wie für Beispiel 2 angegeben zur Härtung gegeben. Dabei werden die C=C-Doppelbindungen der Norbornengruppen, möglicherweise auch die der Methacrylgruppen, im Rahmen einer photoinduzierten radikalischen Polyaddition/ Polymerisation umgesetzt.

E-Modul, Zug-E-Modul und maximale Dehnung werden wie für Beispiel 2 angegeben bestimmt. Die Ergebnisse sind in Tabelle 1 dargestellt.

### Beispiele 4a - 4c

### (Synthese von Basisharz II unter Verwendung eines jeweils unterschiedlichen Unterschusses an Acrylsäurechlorid; siehe DE 10 2011 054 440 A1)

### Beispiel 4a - Basisharz IIa - molarer Anteil des Acrylsäurechlorids = 62%, bezogen auf den molaren Anteil der Hydroxygruppen

Zur Vorlage von 120,1 g (0,45 mol) Basisharz I und 35,1 g Triethylamin (0,347 mol) in 450 ml THF als Lösungsmittel werden unter trockener Atmosphäre und Kühlung mittels Eisbad unter Rühren 28,51 g (0,315 mol) Acrylsäurechlorid zugetropft und bei RT weitergerührt. Die Umsetzung kann mittels NMR sowie über die Abnahme der Säurechlorid-Bande mittels IR-Spektrum verfolgt werden. Nach üblicher Aufarbeitung zur Abtrennung des bei der Addition entstehenden Aminhydrochlorids und säurehaltiger Nebenprodukte sowie Abziehen der flüchtigen Bestandteile mit Ölpumpenvakuum resultiert ein flüssiges Harz mit einer Viskosität von ca. 1,5 Pa·s bei 25°C (stark abhängig von den genauen Synthese- und Aufarbeitungsbedingungen insbesondere auch der Vorstufen).

Das Harz wird mit 1% Lucirin TPO versetzt und wie für Beispiel 1 angegeben in Stäbchenformen gebracht. Die (Meth)acrylatgruppen werden im Rahmen einer photoinduzierten radikalischen Polymerisation umgesetzt, wobei das Harz aushärtet. Mittels 3-Punktbiegeversuch wird nach 1,5 Tagen Lagerung bei 40°C (Härtungsvariante A) der E-Modul des resultierenden Stäbchens bestimmt. Das Ergebnis ist in Tabelle 2 dargestellt.

### Beispiel 4b - Basisharz IIb - molarer Anteil des Acrylsäurechlorids = 74%, bezogen auf den molaren Anteil der Hydroxygruppen

Das Beispiel 4a wurde mit einer entsprechend höheren Menge an Acrylsäurechlorid wiederholt.

### Beispiel 4c - Basisharz IIc - molarer Anteil des Acrylsäurechlorids = 96%, bezogen auf den molaren Anteil der Hydroxygruppen

Das Beispiel 4a wurde mit einer entsprechend höheren Menge an Acrylsäurechlorid wiederholt.

### Beispiel 5

### (Umsetzung des Basisharzes IIa gemäß Beispiel 4 mit Cyclopentadien, wobei ein Siloxan mit über Kohlenstoff an Silicium gebundenen Resten entsteht, die teilweise eine und teilweise zwei Norbornenylgruppen aufweisen)

Zur Vorlage von 99,8 g (0,33 mol) Basisharz IIa nach Beispiel 4 werden unter Rühren bei ca. 50°C ca. 20,3 g (0,31 mol) Cyclopentadien (CP) zugetropft. Nach Erhitzen der Reaktionsmischung auf ca. 90°C werden unter Rühren 43,0 g (0,65 mol) CP zudestilliert und danach noch ca. 1,5 h bei 90°C weitergerührt. Die Umsetzung kann wie voranstehend beschrieben verfolgt werden. Die flüchtigen Bestandteile werden im Ölpumpenvakuum bei Temperaturen bis zu 90°C abgezogen. Es resultiert ein flüssiges Harz mit einer Viskosität von ca. 185 Pa·s bei 25°C. Eine weitere Aufarbeitung ist in der Regel nicht erforderlich.

### Härtung (I)

Das Harz wird nach Zusatz des Trithiols TMPMP (molares Verhältnis SH : C=C = 1 : 1) und 0,5 % Lucirin TPO (Lichthärtung + 1,5 Tage 40 °C = Härtung A bzw. Lichthärtung + 1,5 Tage 80 °C = Härtung B) bzw. mit 1,5 mMol DBPO/100 g Harz und 2,4 mMol N,N-Bis-2-hydroxyethyl-p-toluidin/100 g Harz (2K-Härtung bei 80 °C = Härtung C jeweils bis zur Konstanz der mechanischen Daten) in Stäbchenformen (2 x 2 x 25 mm³ bzw. in eine knochenförmige Stäbchenform mit einem Messlängen-Abschnitt von 21 mm ohne die knochenförmigen Enden) zur Härtung gegeben. Dabei werden die C=C-Doppelbindungen der Norbornengruppen im Rahmen einer photo- bzw. redox-induzierten radikalischen Polyaddition umgesetzt.

E-Modul, Zug-E-Modul und maximale Dehnung werden wie für Beispiel 2 angegeben bestimmt. Die Ergebnisse sind in Tabelle 2 dargestellt.

### Härtung (II)

Die Härtungen gemäß (I) wird mit der Änderung wiederholt, dass das molare Verhältnis von SH : C=C auf 0,9 : 1 eingestellt wird. E-Modul, Zug-E-Modul und maximale Dehnung werden wie für Beispiel 2 angegeben bestimmt. Die Ergebnisse sind in Tabelle 2 dargestellt.

### Beispiel 6

Beispiel 5 wird mit der Änderung wiederholt, dass zur Vorlage von 92,4 g (0,03 mol) Basisharz IIb unter Rühren bei ca. 50°C ca. 22,0 g (0,33 mol) CP zugetropft werden. Nach Erhitzen der Reaktionsmischung auf ca. 90°C werden unter Rühren 39,2 g (0,59 mol) CP zudestilliert und danach noch ca. 1,5 h bei 90°C weitergerührt. Die flüchtigen Bestandteile werden im Ölpumpenvakuum bei Temperaturen bis zu 90°C abgezogen. Es resultiert ein flüssiges Harz mit einer Viskosität von ca. 380 Pa·s bei 25°C. Eine weitere Aufarbeitung ist in der Regel nicht erforderlich.

Das Harz wird nach Zusatz des Trithiols TMPMP (molares Verhältnis SH : C=C = 1 : 1) und 0,5% Lucirin TPO (Lichthärtung + 1,5 Tage 40°C = Härtung A in Stäbchenformen wie für Beispiel 3 beschrieben zur Härtung gegeben. Dabei werden die C=C-Doppelbindungen der Norbornengruppen im Rahmen einer photoinduzierten radikalischen Polyaddition umgesetzt.

E-Modul, Zug-E-Modul und maximale Dehnung werden wie für Beispiel 2 angegeben bestimmt. Die Ergebnisse sind in Tabelle 2 dargestellt.

### Beispiel 7

Beispiel 5 wird mit der Änderung wiederholt, dass zur Vorlage von 111,5 g (0,35 mol) Basisharz IIc unter Rühren bei ca. 50°C ca. 33,3 g (0,50 mol) CP zugetropft werden. Nach Erhitzen der Reaktionsmischung auf ca. 90°C werden unter Rühren 50,5 g (0,77 mol) CP zudestilliert und danach noch ca. 1 h bei 90°C weitergerührt. Die flüchtigen Bestandteile, werden im Ölpumpenvakuum bei Temperaturen bis zu 90°C abgezogen. Es resultiert ein flüssiges Harz mit einer Viskosität von ca. 1030 Pa·s bei 25°C. Eine weitere Aufarbeitung ist in der Regel nicht erforderlich.

Das Harz wird nach Zusatz des Trithiols TMPMP (molares Verhältnis SH : C=C = 1 : 1) und 0,5% Lucirin TPO (Lichthärtung + 1,5 Tage 40°C = Härtung A) in Stäbchenformen gegeben wie für Beispiel 3 beschrieben. Dabei werden die C=C-Doppelbindungen der Norbornengruppen im Rahmen einer photoinduzierten radikalischen Polyaddition umgesetzt.

E-Modul, Zug-E-Modul und maximale Dehnung werden wie für Beispiel 2 angegeben bestimmt. Die Ergebnisse sind in Tabelle 2 dargestellt.

**Tab. 1**

| Harzsystem (Beispiel) | SH : C=C | Härtungsvariante | Biege-E-Modul [MPa] | Zug-E-Modul [MPa] | Zug-Dehnung [%] |
|---|---|---|---|---|---|
| 1 | - | A | 1,50 GPa; die Proben brechen beim Biegeversuch bei einer Durchbiegung von 2,9 mm, d. h. sie zeigen das typische Sprödbruchverhalten | | |
| 2 | 1 : 1 | A | 9,2 - 9,4 (kein Bruch) | 3,8 - 3,9 | 68-81 |
| 2 | 1 : 1 | C | 5,3 (kein Bruch) | 1,9 | 46 |
| 2 | 1 : 1 | D | 10,3 (kein Bruch) | 2,9 | 111 |
| 3 | 1 : 1 | A | 14,4 (kein Bruch) | n.b. | n.b. |

**Tab. 2**

| Harzsystem (Beispiel) | SH : C=C | Härtungsvariante | Temp. Polymerisation [°C] | Biege-E-Modul [MPa] | Zug-E-Modul [MPa] | Zug-Dehnung [%] |
|---|---|---|---|---|---|---|
| 4a | - | A | n. b. | 1,74 GPa; die Proben brechen beim Biegeversuch bei einer Durchbiegung von 2,9 mm, d. h. sie zeigen das typische Sprödbruchverhalten | | |
| 5(I) | 1 : 1 | A | | 1,32 GPa (kein Bruch) | 390 | 28 |
| 5(I) | 1 : 1 | B | | 1,57 GPa (kein Bruch) | 480 | 27 |
| 5(I) | 1 : 1 | C | | 1,44 GPa (kein Bruch) | 380 | 10 |
| 5(II) | 0,9 : 1 | A | | 1,65 GPa (kein Bruch) | 460 | 19 |
| 5(II) | 0,9 : 1 | B | | 1,75 GPa (kein Bruch) | 520 | 30 |
| 5(II) | 0,9 : 1 | C | | 1,37 GPa (kein Bruch) | 250 | 21 |
| 6 | 1 : 1 | A | | 1,76 GPa (kein Bruch) | 520 | 18 |
| 7 | 1 : 1 | A | | 1,93 GPa (kein Bruch) | 510 | 19 |
| 7 | 1 : 1 | B | | 2,10 GPa (kein Bruch) | 550 | 17 |

### Beispiele zur Erläuterung der Erfindung

### Beispiel 8

### Umsetzung des Harzsystems gemäß Beispiel 2 mit Trimethylolpropantri(3-mercaptopropionat) (TMPMP) und "Laserschreiben" im dabei erhaltenen Harz

### Variante 1 (mit Photoinitiator)

Das Norbornenyl-funktionalisierte Grundharzsystem wird nach Zusatz des Trithiols TMPMP (molares Verhältnis SH : C=C = 1 : 1) mit gelöstem Lucirin TPO (0,5 Gew.-%) versetzt und anschließend auf ein beliebiges Substrat (hier: Glassubstrat) für die weitere Prozessierung mittels Zwei- oder Mehr-Photonen-Absorption appliziert. Die organische Vernetzung wird durch den Femtosekundenlaser, der einen Zwei- oder Mehr-Photonen-Polymerisationsprozess initiiert, ausgelöst. Im Beispiel wurde ein Zwei-Photonen-Polymerisationsprozess des Harzes durch Laserlicht einer Wellenlänge von 515 nm bei einer Repetitionsrate von 10 MHz ausgelöst. Andere Wellenlängen zur Belichtung und andere Repetitionsraten sind jedoch auch in beliebiger Kombination möglich. Durch Verfahren des Lasers im Volumen oder an der Oberfläche des Harzes konnten so Strukturen hergestellt werden. Die Strukturierung wurde bei verschiedenen mittleren Laserleistungen beginnend bei ca. 4 mW und inkremental in 0,25 mW-Schritten absteigend bis auf eine mittlere Laserleistung von 0,25 mW variiert. Es wurden 17 Strukturen einer Größe von je 25 µm Kantenlänge mit 20 Lagen, was mit den gewählten Slice-Abständen einer Strukturhöhe von ca. 10 µm entspricht, durch den Zwei-Photonen-Prozess geschrieben. Die Schreibgeschwindigkeit betrug 100 µm/s.

Die Strukturierung erfolgte in einem Sandwich-Aufbau (Deckglas oben und unten, getrennt durch einen Abstandshalter und ein Tropfen des mit Initiator formulierten Harzes dazwischen) mittels TPA (2PP) mit einem Immersionsobjektiv einer numerischem Apertur von N.A. = 1,4.

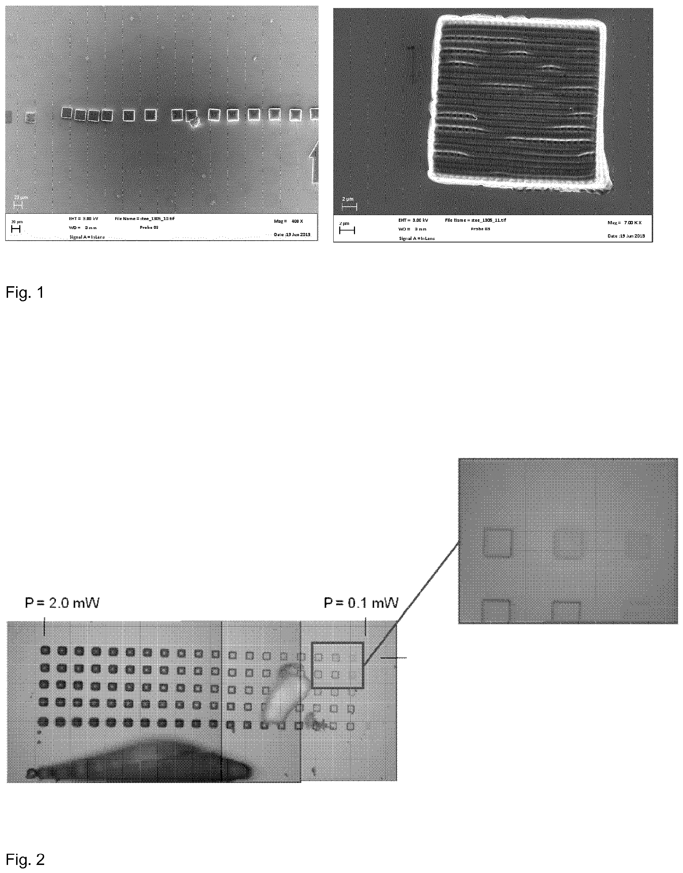

Nach der Laserstrukturierung wurden die Strukturen in einem Entwicklerbad, bestehend aus einer Mischung aus Isopropanol und Methylisobutylketon in einem Mischungsverhältnis von 1:1 für ca. 3 min. entwickelt und anschließend an Luft getrocknet und gelagert. **Figur 1** zeigt rasterelektronenmikroskopische Aufnahmen der erhaltenen Strukturen. Dieses Beispiel zeigt, dass sich das erfindungsgemäße Material unter den Bedingungen der TPA polymerisieren lässt, wobei verfestigte Strukturen mit ggf. extrem geringen Abmessungen in zwei der drei Raumrichtungen erhalten werden können, die beispielsweise als photonische Struktur oder auch als Trägerstruktur (Scaffold) mit einer erzeugbaren Porosität, genutzt werden können.

### Variante 1a (mit Photoinitiator)

Wie Variante 1. Die Strukturen werden mit TPA in flüssiges Harz geschrieben, allerdings werden nur 0,3 Gew.-% Lucirin zugesetzt. Das Laserlicht (Wellenlänge 515 nm) induziert dabei eine Zwei-Photonen-Polymerisation (2PP). Durch Zwei- oder Mehr-Photonen-Absorption (TPA/MPA) angeregte Vernetzungsprozesse (bei anderen Wellenlängen, d.h. Prozesse höherer Ordnung) können ebenfalls durchgeführt werden. Die Strukturierung erfolgt in einem Sandwich-Aufbau (Deckglas oben und unten, getrennt durch einen Abstandshalter und ein Tropfen des mit Initiator formulierten Harzes dazwischen) mittels TPA (2PP) mit einem Immersionsobjektiv einer numerischem Apertur von N.A. = 1,4. Die Entwicklung der Strukturen wird in MIBK vorgenommen. Die Schreibgeschwindigkeit betrug 100 µm/s; die Energie des Lasers betrug teils 2,0 mW und wurde pro Struktur in 0,25 mW-Schritten bis auf 1 mW reduziert. Die Größe einer in **Figur 2** mittels optischer Mikroskopie aufgenommenen Struktur beträgt 10 µm x 10 µm x 7,5 µm.

### Variante 2 (ohne Photoinitiator)

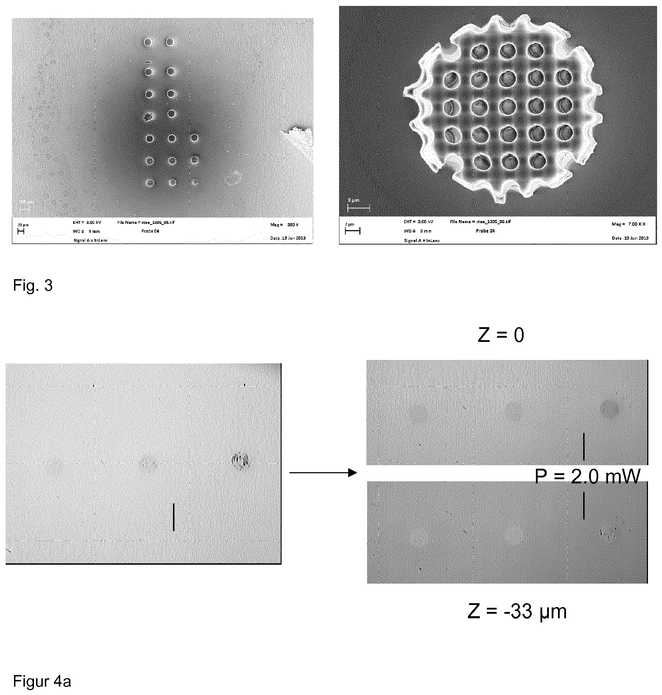

Das Norbornenyl-funktionalisierte Grundharzsystem wird nach Zusatz des Trithiols TMPMP (molares Verhältnis SH : C=C = 0,9 : 1) ohne weiteren Zusatz eines Initiators auf ein beliebiges Substrat (hier: Glassubstrat) für die weitere Prozessierung mittels Mehr-Photonen-Absorption appliziert. Die organische Vernetzung wird durch den Femtosekundenlaser, der einen Mehr-Photonen-Polymerisationsprozess initiiert, ausgelöst. Im Beispiel wurde ein Zwei-Photonen-Polymerisationsprozess des Harzes durch Laserlicht einer Wellenlänge von 515 nm bei einer Repetitionsrate von 10 MHz ausgelöst. Andere Wellenlängen zur Belichtung und andere Repetitionsraten sind jedoch auch in beliebiger Kombination möglich. Durch Verfahren des Lasers im Volumen oder an der Oberfläche des Harzes konnten so Strukturen hergestellt werden. Die Strukturierung wurde bei verschiedenen mittleren Laserleistungen beginnend bei ca. 4 mW und inkremental in 0,25 mW-Schritten absteigend bis auf eine mittlere Laserleistung von 0,25 mW variiert. Es wurden 17 Strukturen einer Größe von 25 µm Kantenlänge mit 20 Lagen, was mit den gewählten Slice-Abständen einer Strukturhöhe von ca. 10 µm entspricht, durch den Zwei-Photonen-Prozess geschrieben. Die Schreibgeschwindigkeit betrug 100 µm/s. Nach der Laserstrukturierung wurden die Strukturen in einem Entwicklerbad, bestehend aus einer Mischung aus Isopropanol und Methylisobutylketon in einem Mischungsverhältnis von 1:1 für ca. 3 min. entwickelt und anschließend an Luft getrocknet und gelagert. **Figur 3** zeigt Rastermikroskop-Aufnahmen der erhaltenen Strukturen, die beispielsweise als Trägerstruktur (Scaffold) mit einer erzeugbaren Porosität, genutzt werden können.

### Beispiel 9 (mit Photoinitiator, vorverfestigtes Material)

Das Norbornenyl-funktionalisierte Grundharzsystem gemäß Beispiel 2 (Variante 1) wird nach Zusatz des Trithiols TMPMP (molares Verhältnis SH : C=C = 0,5 : 1) mit 0,3 Gew.-% Lucirin auf ein beliebiges Substrat (hier: Glassubstrat) appliziert. Das Harz wird vor der TPA bzw. MPA mittels Licht der Wellenlänge 200 bis 500 nm vorbelichtet, wobei diese Vorbelichtung zwischen 1 und 3600 s dauern kann. Im gewählten Beispiel betrug die Vorbelichtungszeit 360 s, so dass das Material vollkommen verfestigt wird. Anschließend wurde der Laser mittels eines Objektivs einer numerischen Apertur von 1,4 in das verfestigte Material fokussiert und so Strukturen mittels TPA bei Verwendung einer Wellenlänge von 515 nm in dem Material erzeugt. Das Laserlicht induziert dabei eine weitere Vernetzung/Verdichtung des vorvernetzten Materials durch Zwei-Photonen-Polymerisation (2PP). Durch Multi-Photon-Absorption (MPA) angeregte Vernetzungsprozesse (bei anderen Wellenlängen, d.h. Prozesse höherer Ordnung) können ebenfalls durchgeführt werden.

Die Strukturen sind als Volumenstrukturen im Formkörper oder der Schicht vorhanden und werden nicht entwickelt (Lösemittelfreier Prozess).

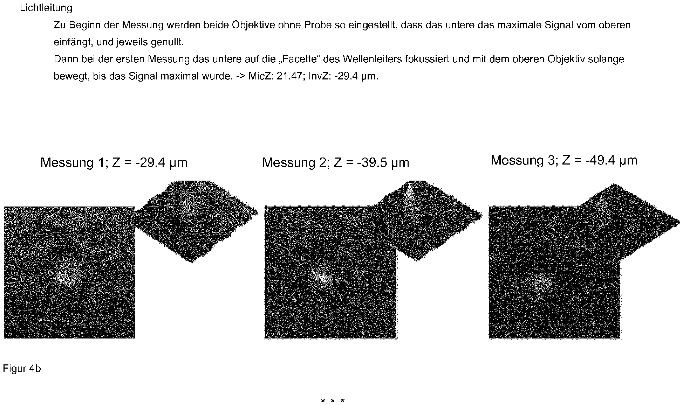

Durch die Strukturierung wird ein Brechzahlhub erzeugt. Dies lässt sich indirekt anhand von Aufnahmen mit dem Auflichtmikroskop beweisen, die als Figur 4 (a) und (b) beigefügt sind und die Lichtleitung innerhalb der "geschriebenen" Strukturen erkennen lassen: Nur dann, wenn eine Brechzahldifferenz zwischen der "geschriebenen" Struktur und deren Umgebung vorhanden ist, wird tritt an der Grenze der Struktur zu ihrer Umgebung Totalreflexion auf, so dass die Struktur als Wellenleiter fungieren kann.

## Patentansprüche

1. Schicht oder dreidimensionaler Formkörper aus oder mit einem organisch modifizierten Polysiloxan oder einem Derivat davon, dessen Siliciumatome teilweise durch andere Metallatome ersetzt sind, wobei der organische Anteil des Polysiloxans oder Derivats davon ein organisches Netzwerk mit über Kohlenstoff an Silicium und ggf. andere Metallatome gebundenen Thiol-En-Additionsprodukten, die über eine 2- oder Mehrphotonenpolymerisationsreaktion erhältlich sind, aufweist, wobei der Körper zwei Bereiche mit unterschiedlichen Primär- und/oder Sekundärstrukturen aufweist, erhältlich durch das folgende Verfahren:
a) Bereitstellen eines Substrats oder einer Form,
b) Bereitstellen eines Materials, ausgewählt unter organisch modifizierten, polysiloxanhaltigen Materialien, wobei das bereitgestellte Material freie SH-Gruppen und isolierte C=C-Doppelbindungen aufweist,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) thermisches und/oder photochemisches Behandeln des gesamten auf dem Substrat bzw. in der Form befindlichen Materials,
mit der Maßgabe, dass die Schritte d) und e) in beliebiger Abfolge durchgeführt werden können.

2. Schicht oder dreidimensionaler Formkörper nach Anspruch 1, worin das gemäß Schritt (b) bereitgestellte Material ausgewählt ist unter:
1. einer Mischung aus oder enthaltend (a) ein organisch modifiziertes, polysiloxanhaltiges Material, das über ein Kohlenstoffatom an Silicium gebundene organische Gruppen aufweist, die mit einer oder mehreren SH-Gruppen substituiert sind, und (b) eine rein organische Verbindung, die zwei oder mehr isolierte C=C-Bindungen aufweist,
2. einer Mischung, aus oder enthaltend (a) ein organisch modifiziertes, polysiloxanhaltiges Material, das über ein Kohlenstoffatom an Silicium gebundene organische Gruppen aufweist, die eine oder mehrere isolierte C=C-Doppelbindungen besitzen, und (b) eine rein organische Verbindung, die mit zwei oder mehr SH-Gruppen substituiert ist, und
3. einer Mischung aus oder enthaltend (a) ein organisch modifiziertes, polysiloxanhaltiges Material, das über ein Kohlenstoffatom an Silicium gebundene organische Gruppen aufweist, die mit einer oder mehreren SH-Gruppen substituiert sind, und (b) ein organisch modifiziertes, polysiloxanhaltiges Material, das über ein Kohlenstoffatom an das Metall/Halbmetall gebundene organische Gruppen aufweist, die eine oder mehrere isolierte C=C-Bindungen besitzen.

3. Schicht oder Formkörper nach einem der Ansprüche 1 und 2, worin das gemäß Stufe b) bereitgestellte Material ein organisch modifiziertes polysiloxanhaltiges Material umfasst, das durch Hydrolyse und mindestens teilweise Kondensation eines Ausgangsmaterials erhältlich ist, welches mindestens ein Silan der Formel (I)
R¹ₐR²_{b}SiX_{4-a-b} (I)
worin R¹ gleich oder verschieden ist und einen organischen, über Zwei- oder Mehrphotonenpolymerisation polymerisierbaren Rest darstellt, der mindestens eine isolierte C=C-Doppelbindung trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Thiosilan oder ein organisches Thiol mit mindestens zwei SH-Gruppe umfasst oder daraus besteht.

4. Schicht oder Formkörper nach einem der Ansprüche 1 und 2, worin das gemäß Stufe (b) bereitgestellte Material ein organisch modifiziertes polysiloxanhaltiges Material umfasst, das durch Hydrolyse und mindestens teilweise Kondensation eines Ausgangsmaterials erhältlich ist, welches mindestens ein Silan der Formel (I')
R³ₐR²_{b}SiX_{4-a-b} (I')
worin R³ gleich oder verschieden ist und einen organischen, über Zwei- oder Mehrphotonenpolymerisation polyaddierbaren Rest darstellt, der mindestens eine SH-Gruppe trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Silan der Formel (I) wie in Anspruch 3 angegeben oder eine organische, mindestens eine isolierte C=C-Doppelbindung enthaltende Verbindung umfasst oder daraus besteht.

5. Schicht oder Formkörper nach einem der voranstehenden Ansprüche, worin die Bereiche mit unterschiedlichen Primär- und/oder Sekundärstrukturen unterschiedliche Brechungsindices und/oder unterschiedliche Vernetzungsstrukturen besitzen.

6. Verfahren zum Herstellen einer dreidimensionalen Schicht oder eines dreidimensionalen Formkörpers, der zwei Bereiche mit unterschiedlichen Primär- und/oder Sekundärstrukturen aufweist, umfassend die Schritte:
a) Bereitstellen eines Substrats oder einer Form,
b) Bereitstellen eines Materials, das ausgewählt ist unter organisch modifizierten, polysiloxanhaltigen Materialien und freie SH-Gruppen und isolierte C=C-Doppelbindungen aufweist,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) thermisches und/oder photochemisches Behandeln des gesamten auf dem Substrat bzw. in der Form befindlichen Materials,
mit der Maßgabe, dass die Schritte d) und e) in beliebiger Abfolge durchgeführt werden können.

7. Verfahren nach Anspruch 6, wobei das gemäß Schritt (b) bereitgestellte Material ausgewählt ist unter:
1. einer Mischung aus oder enthaltend (a) ein organisch modifiziertes, polysiloxanhaltiges Material, das über ein Kohlenstoffatom an Silicium gebundene organische Gruppen aufweist, die mit einer oder mehreren SH-Gruppen substituiert sind, und (b) eine rein organische Verbindung, die zwei oder mehr isolierte C=C-Bindungen aufweist,
2. einer Mischung aus oder enthaltend (a) ein organisch modifiziertes, polysiloxanhaltiges Material, das über ein Kohlenstoffatom an Silicium gebundene organische Gruppen aufweist, die eine oder mehrere isolierte C=C-Doppelbindungen besitzen, und (b) eine rein organische Verbindung, die mit zwei oder mehreren SH-Gruppen substituiert ist, und
3. einer Mischung aus oder enthaltend (a) ein organisch modifiziertes, polysiloxanhaltiges Material, das über ein Kohlenstoffatom an Silicium gebundene organische Gruppen aufweist, die mit einer oder mehreren SH-Gruppen substituiert sind, und (b) ein organisch modifiziertes, polysiloxanhaltiges Material, das über ein Kohlenstoffatom an das Silicium gebundene organische Gruppen aufweist, die eine oder mehrere isolierte C=C-Bindungen besitzen.

8. Verfahren nach einem der Ansprüche 6 und 7, worin das gemäß Stufe (b) bereitgestellte Material ein organisch modifiziertes polysiloxanhaltiges Material ist, ausgewählt unter:
einem organisch modifizierten polysiloxanhaltigen Material, das durch Hydrolyse und
mindestens teilweise Kondensation eines Ausgangsmaterials erhältlich ist, welches mindestens ein Silan der Formel (I)
R¹ₐR²_{b}SiX_{4-a-b} (I)
worin R¹ gleich oder verschieden ist und einen organischen, über Zwei- oder Mehrphotonenpolymerisation polymerisierbaren Rest darstellt, der mindestens eine isolierte C=C-Doppelbindung trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Thiosilan oder eine organisches Thiol mit mindestens zwei SH-Gruppe umfasst oder daraus besteht, und/oder
einem organisch modifizierten polysiloxanhaltigen Material, das durch Hydrolyse und mindestens teilweise Kondensation eines Ausgangsmaterials erhältlich ist, welches mindestens ein Silan der Formel (I')
R³ₐR²_{b}SiX_{4-a-b} (1')
worin R³ gleich oder verschieden ist und einen organischen, über Zwei- oder Mehrphotonenpolymerisation polyaddierbaren Rest darstellt, der mindestens eine SH-Gruppe trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Silan der Formel (I) wie oben angegeben oder eine organische, mindestens eine isolierte C=C-Doppelbindung enthaltende Verbindung umfasst oder daraus besteht.

9. Verfahren nach einem der Ansprüche 6 bis 8, **dadurch gekennzeichnet, dass** das Ausgangsmaterial weiterhin enthält:
mindestens ein weiteres Silan der Formel (II)
SiX₄ (II)
worin X gleich oder verschieden ist und die gleiche Bedeutung wie in Formel (I) besitzt, und/oder
mindestens ein weiteres Silan der Formel (III)
R⁴ₐSi(OH)₄₋ₐ (III)
worin R⁴ gleich oder verschieden sein kann und entweder die Bedeutung von R¹ wie in Formel (I) definiert oder von R² wie in Formel (I) definiert besitzt und worin der Index a 1, 2 oder 3 bedeutet, enthält.

10. Verfahren zum Herstellen einer dreidimensionalen Schicht oder eines dreidimensionalen Formkörpers, umfassend die Schritte:
a) Bereitstellen eines Substrats oder einer Form,
b) Bereitstellen eines organisch modifizierten, polysiloxanhaltigen Materials, das freie SH-Gruppen und isolierte C=C-Doppelbindungen aufweist,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) Trennen des Formkörpers von nicht-belichtetem Material durch Waschen des Körpers in einem Lösungsmittel, in welchem sich das gemäß Schritt (b) bereitgestellte Material löst.

11. Verfahren nach Anspruch 10, wobei das gemäß Schritt (b) bereitgestellte Material ausgewählt ist unter:
1. einer Mischung aus oder enthaltend (a) ein organisch modifiziertes, polysiloxanhaltiges Material, das über ein Kohlenstoffatom an Silicium gebundene organische Gruppen aufweist, die mit einer oder mehreren SH-Gruppen substituiert sind, und (b) eine rein organische Verbindung, die zwei oder mehr isolierte C=C-Bindungen aufweist,
2. einer Mischung aus oder enthaltend (a) ein organisch modifiziertes, polysiloxanhaltiges Material, das über Kohlenstoff an Silicium gebundene organische Gruppen aufweist, die eine oder mehrere isolierte C=C-Doppelbindungen besitzen, und (b) eine rein organische Verbindung, die mit zwei oder mehreren SH-Gruppen substituiert ist, und
3. einer Mischung aus oder enthaltend (a) organisch modifiziertes, polysiloxanhaltiges Material, das über ein Kohlenstoffatom an Silicium gebundene organische Gruppen aufweist, die mit einer oder mehreren SH-Gruppen substituiert sind, und (b) ein organisch modifiziertes, polysiloxanhaltiges Material, das über ein Kohlenstoffatom an Silicium gebundene organische Gruppen aufweist, die eine oder mehrere isolierte C=C-Bindungen besitzen.

12. Verfahren nach Anspruch 11, worin das gemäß Stufe (b) bereitgestellte Material ein organisch modifiziertes polysiloxanhaltiges Material umfasst, das durch Hydrolyse und mindestens teilweise Kondensation eines Ausgangsmaterials erhältlich ist, welches entweder mindestens ein Silan der Formel (I)
R¹ₐR²_{b}SiX_{4-a-b} (I)
worin R¹ gleich oder verschieden ist und einen organischen, über Zwei- oder Mehrphotonenpolymerisation polymerisierbaren Rest darstellt, der mindestens eine isolierte C=C-Doppelbindung trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Thiosilan oder eine organisches Thiol mit mindestens zwei SH-Gruppe umfasst oder daraus besteht, und/oder
mindestens ein Silan der Formel (I')
R³ₐR²_{b}SiX_{4-a-b} (I')
worin R³ gleich oder verschieden ist und einen organischen, über Zwei- oder Mehrphotonenpolymerisation polymerisierbaren Rest darstellt, der mindestens eine SH-Gruppe trägt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, sowie ein Silan der Formel (I) wie oben angegeben oder eine organische, mindestens eine isolierte C=C-Doppelbindung enthaltende Verbindung umfasst oder daraus besteht.

13. Verfahren nach Anspruch 12, **dadurch gekennzeichnet, dass** das Ausgangsmaterial weiterhin mindestens ein weiteres Silan der Formel (II)
SiX₄ (II)
worin X gleich oder verschieden ist und die gleiche Bedeutung wie in Formel (I) besitzt, enthält und/oder dass das Ausgangsmaterial weiterhin mindestens ein weiteres Silan der Formel (III)
R⁴ₐSi(OH)₄₋ₐ (III)
worin R⁴ gleich oder verschieden sein kann und entweder die Bedeutung von R¹ wie in Formel (I) definiert oder von R² wie in Formel (I) definiert besitzt und worin der Index a 1, 2 oder 3 bedeutet, enthält.

14. Verfahren nach einem der Ansprüche 10 bis 13 zur Erzeugung eines porösen Formkörpers, insbesondere eines Formkörpers mit Poren im µm- oder nm-Bereich und/oder eines als Scaffold geeigneten Formkörpers.

15. Verwendung eines Formkörpers nach einem der Ansprüche 1 bis 5 als Wellenleiter.

## Claims

1. A layer or three-dimensional molded article consisting of or comprising an organically modified polysiloxane or a derivative thereof, the silicon atoms of which are partially replaced by other metal atoms, wherein the organic share of the polysiloxane or derivative thereof has an organic cross-link with thiol-ene addition products bonded to silicon and optionally to other metal atoms via carbon, which are obtainable via a two-photon or multi-photon polymerization reaction, wherein the article has two areas with differing primary and/or secondary structures, available through the following process:
a) providing a substrate or a mold,
b) providing a material selected from organically modified materials containing polysiloxanes, wherein said provided material has free SH groups and isolated C=C double bonds,
c) applying or attaching the provided material on or to the substrate or pouring it into the mold,
d) selective exposure of a selected area of material located on the substrate or in the mold with the help of two-photon or multi-photon polymerization,
e) thermal and/or photochemical treatment of the entire material located on the substrate or in the mold,
with the provision that steps d) and e) can be conducted in any sequence.

2. The layer or three-dimensional molded article according to Claim 1, wherein the material provided according to step (b) is selected from:
1. a mixture consisting of or comprising (a) an organically modified material containing polysiloxanes and having organic groups bonded to silicon via a carbon atom, which are substituted with one or more SH groups, and (b) a purely organic compound having two or more isolated C=C bonds,
2. a mixture consisting of or comprising (a) an organically modified material containing polysiloxanes and having organic groups bonded to silicon via a carbon atom, which have two or more isolated C=C bonds, and (b) a purely organic compound, which is substituted with one or more SH groups, and
3. a mixture consisting of or comprising (a) an organically modified material containing polysiloxanes and having organic groups bonded to silicon via a carbon atom, which are substituted with one or more SH groups, and (b) an organically modified material containing polysiloxanes and having organic groups bonded to the metal/metalloid via a carbon atom, which have one or more isolated C=C bonds.

3. The layer or three-dimensional molded article according to Claim 1 or 2, wherein the material provided according to step (b) comprises an organically modified material containing polysiloxanes, which is obtainable through hydrolysis and at least partial condensation of a starting material comprising or consisting of at least one silane of a formula (I),
R¹ₐR²_{b}SiX_{4-a-b} (I)
wherein R¹ is equal or different and represents a radical polymerizable via two-photon or multi-photon polymerization, which carries at least one isolated C=C double bond, R² is equal or different and represents an organic radical that is not polymerizable in this manner, and X is a radical that can be hydrolyzed from silicon under hydrolysis conditions, the index a represents 1, 2 or 3, the index b represents 1 or 2, and a+b together are 1, 2 or 3, as well as thiosilane or an organic thiol with at least two SH groups.

4. The layer or three-dimensional molded article according to Claim 1 or 2, wherein the material provided according to step (b) comprises an organically modified material containing polysiloxanes, which is obtainable through hydrolysis and at least partial condensation of a starting material comprising or consisting of at least one silane of a formula (I'),
R³ₐR²_{b}SiX_{4-a-b} (I')
wherein R³ is equal or different and represents an organic radical capable of polyaddition via two-photon or multi-photon polymerization, which carries at least one SH group, R² is equal or different and represents an organic radical that is not polymerizable in this manner, and X is a radical that can be hydrolyzed out of silicon under hydrolysis conditions, the index a represents 1, 2 or 3, the index b represents 1 or 2, and a+b together are 1, 2 or 3, as well as a silane of said formula (I) as specified in Claim 3, or an organic compound containing at least one isolated C=C double bond.

5. A layer or three-dimensional molded article according to one of the previous Claims, wherein the areas with different primary and/or secondary structures have different refractive indices, and/or different cross-linking structures.

6. A method for producing a three-dimensional layer or a three-dimensional molded article having two areas with different primary and/or secondary structures, comprising the steps:
a) providing a substrate or a mold,
b) providing a material selected from organically modified materials containing polysiloxanes, wherein said provided material is selected from sols, gels, and organically modified materials containing polysiloxanes containing metal and/or metalloid and has free SH groups and isolated C=C double bonds,
c) applying or attaching the provided material on or to the substrate or pouring it into the mold,
d) selective exposure of a selected area of material located on the substrate or in the mold with the help of two-photon or multi-photon polymerization,
e) thermal and/or photochemical treatment of the entire material located on the substrate or in the mold,
with the provision that steps d) and e) can be conducted in any sequence.

7. The method according to Claim 6, wherein the material provided according to step (b) is selected from:
1. a mixture consisting of or comprising (a) an organically modified material containing polysiloxanes and having organic groups bonded to silicon via a carbon atom, which are substituted with one or more SH groups, and (b) a purely organic compound, which has two or more isolated C=C bonds,
2. a mixture consisting of or comprising (a) an organically modified material containing polysiloxanes and having organic groups bonded to silicon via a carbon atom, which have one or more isolated C=C double bonds, and (b) a purely organic compound, which is substituted with two or more SH groups, and
3. a mixture consisting of or comprising (a) an organically modified material containing polysiloxanes and having organic groups bonded to silicon via a carbon atom, which are substituted with one or more SH groups, and (b) an organically modified material containing polysiloxanes and having organic groups bonded to silicon via a carbon atom, which have one or more isolated C=C bonds.

8. The method according to Claim 6 or 7, wherein the material provided according to step (b) is an organically modified material containing polysiloxanes, selected from an organically modified material containing polysiloxanes, which is obtainable through hydrolysis and at least partial condensation of a starting material consisting of or comprising at least one silane of a formula (I),
R¹ₐR²_{b}SiX_{4-a-b} (I)
wherein R¹ is equal or different and represents a radical polymerizable via two-photon or multi-photon polymerization, which carries at least one isolated C=C double bond, R² is equal or different and represents an organic radical that is not polymerizable in this manner, and X is a radical that can be hydrolyzed out of silicon under hydrolysis conditions, the index a represents 1, 2 or 3, the index b represents 1 or 2, and a+b together are 1, 2 or 3, as well as a thiosilane or an organic thiol with at least two SH groups, and/or an organically modified material containing polysiloxanes, which is obtainable through hydrolysis and at least partial condensation of a starting material consisting of or comprising at least one silane of a formula (I'),
R³ₐR²_{b}SiX_{4-a-b} (I')
wherein R³ is equal or different and represents an organic radical capable of polyaddition via two-photon or multi-photon polymerization, which carries at least one SH group, R² is equal or different and represents an organic radical that is not polymerizable in this manner, and X is a radical that can be hydrolyzed out of silicon under hydrolysis conditions, the index a represents 1, 2 or 3, the index b represents 1 or 2, and a+b together are 1, 2 or 3, as well as a silane of said formula (I) as specified above or an organic compound containing at least one isolated C=C double bond.

9. The method according to one of the Claims 6 to 8, wherein the starting material also contains at least one additional silane of a formula (II),
SiX₄ (II)
wherein X is equal or different and has the same meaning as in formula (I), and/or at least one additional silane of a formula (III),
R⁴ₐSi(OH)₄₋ₐ (III)
wherein R⁴ can be equal or different and has either the meaning of R¹ as defined in formula (I) or of R² as defined in formula (I), and wherein the index a represents 1, 2 or 3.

10. A method for producing a three-dimensional layer or a three-dimensional molded article comprising the steps:
a) providing a substrate or a mold,
b) providing an organically modified material containing polysiloxanes and having free SH groups and isolated C=C double bonds,
c) applying or attaching the provided material on or to the substrate or pouring it into the mold,
d) selective exposure of a selected area of material located on the substrate or in the mold with the help of two-photon or multi-photon polymerization,
e) separating the molded article from non-exposed material by washing the article in a solvent, in which the provided material dissolves pursuant to step (b).

11. The method according to Claim 10, wherein the material provided according to step (b) is selected from:
1. a mixture consisting of or comprising (a) an organically modified material containing polysiloxanes and having organic groups bonded to silicon via a carbon atom, which are substituted with one or more SH groups, and (b) a purely organic compound, which has two or more isolated C=C bonds,
2. a mixture consisting of or comprising (a) an organically modified material containing polysiloxanes and having organic groups bonded silicon via a carbon atom, which have one or more isolated C=C double bonds, and (b) a purely organic compound, which is substituted with two or more SH groups, and
3. a mixture consisting of or comprising (a) a an organically modified material containing polysiloxanes and having organic groups bonded to silicon via a carbon atom, which are substituted with one or more SH groups, and (b) an organically modified material containing polysiloxanes and having organic groups bonded to silicon via a carbon atom, which have one or more isolated C=C bonds.

12. The method according to Claim 10 or 11, wherein the material provided according to step (b) comprises an organically modified material containing polysiloxanes, which is obtainable through hydrolysis and at least partial condensation of a starting material consisting of or comprising either at least one silane of a formula (I),
R¹ₐR²_{b}SiX_{4-a-b} (I)
wherein R¹ is equal or different and represents a radical polymerizable via two-photon or multi-photon polymerization, which carries at least one isolated C=C double bond, R² is equal or different and represents an organic radical that is not polymerizable in this manner, and X is a radical that can be hydrolyzed out of silicon under hydrolysis conditions, the index a represents 1, 2 or 3, the index b represents 1 or 2, and a+b together are 1, 2 or 3, as well as a thiosilane or an organic thiol with at least two SH groups, and/or at least one silane of a formula (I'),
R³ₐR²_{b}SiX_{4-a-b} (I')
wherein R³ is equal or different and represents a radical polymerizable via two-photon or multi-photon polymerization, which carries at least one SH group, R² is equal or different and represents an organic radical that is not polymerizable in this manner, and X is a radical that can be hydrolyzed out of silicon under hydrolysis conditions, the index a represents 1, 2 or 3, the index b represents 1 or 2, and a+b together are 1, 2 or 3, as well as a silane of said formula (I) as specified above or an organic compound containing at least one isolated C=C double bond.

13. The method according to Claim 12, wherein the starting material also contains at least one additional silane of a formula (II),
SiX₄ (II)
wherein X is equal or different and has the same meaning as in formula (I), and/or at least one additional silane of a formula (III),
R⁴ₐSi(OH)₄₋ₐ (III)
wherein R⁴ can be equal or different and has either the meaning of R¹ as defined in formula (I) or of R² as defined in formula (I), and wherein the index a represents 1, 2 or 3.

14. The method according to one of the Claims 10 to 13 for producing a porous molded article, particularly a molded article with pores in the µm or nm range and/or a molded article suitable as a scaffold.

15. Use of a molded article according to one of the Claims 1 to 5 as a waveguide.

## Revendications

1. Couche ou corps moulé tridimensionnel constitué(e) d'un polysiloxane organiquement modifié ou d'un dérivé de ce dernier, dont les atomes de silicium sont partiellement remplacés par d'autres atomes métalliques, dans lequel la fraction organique du polysiloxane ou de son dérivé présente un réseau organique comportant des produits d'addition thiol-ène liés par l'intermédiaire de carbone au silicium et éventuellement à d'autres atomes métalliques, qui peuvent être obtenus au moyen d'une réaction de polymérisation à deux photons ou plus, dans lequel le corps présente deux zones avec des structures primaires et/ou secondaires différentes, qui peut être obtenu(e) par le procédé suivant:
a) préparation d'un substrat ou d'un moule;
b) préparation d'un matériau, sélectionné parmi des matériaux organiquement modifiés renfermant un polysiloxane, dans lequel le matériau préparé présente des groupes SH libres et des liaisons doubles C=C isolées,
c) application ou dépôt du matériau préparé sur le substrat ou introduction dudit matériau dans le moule,
d) exposition sélective d'une zone sélectionnée du matériau se trouvant sur le substrat ou dans le moule à l'aide d'une polymérisation à deux photons ou plus,
e) traitement thermique et/ou photochimique de la totalité du matériau se trouvant sur le substrat ou dans le moule,
avec la condition que les étapes d) et e) peuvent être effectuées dans un ordre quelconque.

2. Couche ou corps moulé tridimensionnel selon la revendication 1, dans lequel/laquelle le matériau préparé selon l'étape (b) est sélectionné parmi:
1. un mélange constitué de ou contenant (a) un matériau organiquement modifié renfermant un polysiloxane, présentant des groupes organiques qui sont liés au silicium par l'intermédiaire d'un atome de carbone et qui sont substitués par un ou plusieurs groupe(s) SH, et (b) un composé purement organique, qui présente deux liaisons doubles C=C isolées ou plus,
2. un mélange constitué de ou contenant (a) un matériau organiquement modifié renfermant un polysiloxane, présentant des groupes organiques qui sont liés au silicium par l'intermédiaire d'un atome de carbone et qui possèdent une ou plusieurs liaison (s) double (s) C=C isolée (s), et (b) un composé purement organique, qui est substitué par deux groupes SH ou plus, et
3. un mélange constitué de ou contenant (a) un matériau organiquement modifié renfermant un polysiloxane, présentant des groupes organiques liés au silicium par l'intermédiaire d'un atome de carbone, qui sont substitués par un ou plusieurs groupe (s) SH, et (b) un matériau organiquement modifié renfermant un polysiloxane, présentant des groupes organiques liés au métal/métalloïde par l'intermédiaire d'un atome de carbone, qui possèdent une ou plusieurs liaison(s) C=C isolée(s).

3. Couche ou corps moulé selon une des revendications 1 et 2, dans lequel/laquelle le matériau préparé selon l'étape (b) comprend un matériau organiquement modifié renfermant un polysiloxane, qui peut être obtenu par hydrolyse et condensation au moins partielle d'un matériau de départ, qui comprend au moins un silane de la formule (I)
R¹ₐR²_{b}SiX_{4-a-b} (I)
dans laquelle R¹ est identique ou différent et représente un radical organique polymérisable par polymérisation à deux photons ou plus, qui porte au moins une liaison double C=C isolée, R² est identique ou différent et représente un radical organique non polymérisable de cette manière, et X est un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un thiosilane ou un thiol organique avec au moins deux groupes SH, ou qui en est constitué.

4. Couche ou corps moulé selon une des revendications 1 et 2, dans lequel/laquelle le matériau préparé selon l'étape (b) comprend un matériau organiquement modifié renfermant un polysiloxane, qui peut être obtenu par hydrolyse et condensation au moins partielle d'un matériau de départ, qui comprend au moins un silane de la formule (I')
R³ₐR²_{b}SiX_{4-a-b} (I')
dans laquelle R³ est identique ou différent et représente un radical organique pouvant être poly-additionné par polymérisation à deux photons ou plus, qui porte au moins un groupe SH, R² est identique ou différent et représente un radical organique non polymérisable de cette manière, et X représente un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un silane de la formule (I) comme indiqué dans la revendication 3 ou un composé organique contenant au moins une liaison double C=C isolée, ou qui en est constitué.

5. Couche ou corps moulé selon l'une quelconque des revendications précédentes, dans lequel/laquelle les zones avec des structures primaires et/ou secondaires différentes possèdent des indices de réfraction différents et/ou des structures de réticulation différentes.

6. Procédé de production d'une couche tridimensionnelle ou d'un corps moulé tridimensionnel, qui présente deux zones avec des structures primaires et/ou secondaires différentes, comprenant les étapes suivantes:
a) préparation d'un substrat ou d'un moule;
b) préparation d'un matériau, qui est sélectionné parmi des matériaux organiquement modifiés renfermant un polysiloxane et qui présente des groupes SH libres et des liaisons doubles C=C isolées,
c) application ou dépôt du matériau préparé sur le substrat ou introduction dudit matériau dans le moule,
d) exposition sélective d'une zone sélectionnée du matériau se trouvant sur le substrat ou dans le moule à l'aide d'une polymérisation à deux photons ou plus,
e) traitement thermique et/ou photochimique de la totalité du matériau se trouvant sur le substrat ou dans le moule,
avec la condition que les étapes d) et e) peuvent être effectuées dans un ordre quelconque.

7. Procédé selon la revendication 6, dans lequel le matériau préparé selon l'étape (b) est sélectionné parmi:
1. un mélange constitué de ou contenant (a) un matériau organiquement modifié renfermant un polysiloxane, présentant des groupes organiques qui sont liés au silicium par l'intermédiaire d'un atome de carbone et qui sont substitués par un ou plusieurs groupe(s) SH, et (b) un composé purement organique, qui présente deux liaisons doubles C=C isolées ou plus,
2. un mélange constitué de ou contenant (a) un matériau organiquement modifié renfermant un polysiloxane, présentant des groupes organiques qui sont liés au silicium par l'intermédiaire d'un atome de carbone et qui possèdent une ou plusieurs liaison (s) double (s) C=C isolée(s), et (b) un composé purement organique, qui est substitué par deux ou plusieurs groupes SH, et
3. un mélange constitué de ou contenant (a) un matériau organiquement modifié renfermant un polysiloxane, présentant des groupes organiques liés au silicium par l'intermédiaire d'un atome de carbone, qui sont substitués par un ou plusieurs groupe (s) SH, et (b) un matériau organiquement modifié renfermant un polysiloxane, présentant des groupes organiques liés au silicium par l'intermédiaire d'un atome de carbone, qui possèdent une ou plusieurs liaison (s) C=C isolée(s).

8. Procédé selon une des revendications 6 et 7, dans lequel le matériau préparé selon l'étape (b) est un matériau organiquement modifié renfermant un polysiloxane, sélectionné parmi:
un matériau organiquement modifié renfermant un polysiloxane, qui peut être obtenu par hydrolyse et condensation au moins partielle d'un matériau de départ, qui comprend au moins un silane de la formule (I)
R¹ₐR²_{b}SiX_{4-a-b} (I)
dans laquelle R¹ est identique ou différent et représente un radical organique polymérisable par polymérisation à deux photons ou plus, qui porte au moins une liaison double C=C isolée, R² est identique ou différent et représente un radical organique non polymérisable de cette manière, et X est un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un thiosilane ou un thiol organique avec au moins deux groupes SH, ou qui en est constitué, et/ou
un matériau organiquement modifié renfermant un polysiloxane, qui peut être obtenu par hydrolyse et condensation au moins partielle d'un matériau de départ, qui comprend au moins un silane de la formule (I')
R³ₐR²_{b}SiX_{4-a-b} (I')
dans laquelle R³ est identique ou différent et représente un radical organique pouvant être poly-additionné par polymérisation à deux photons ou plus, qui porte au moins un groupe SH, R² est identique ou différent et représente un radical organique non polymérisable de cette manière, et X représente un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un silane de la formule (I) comme indiqué ci-dessus ou un composé organique contenant au moins une liaison double C=C isolée, ou qui en est constitué.

9. Procédé selon l'une quelconque des revendications 6 à 8, **caractérisé en ce que** le matériau de départ contient en outre:
au moins un autre silane de la formule (II)
SiX₄ (II)
dans laquelle X est identique ou différent et possède la même signification que dans la formule (I),
et/ou contient
au moins un autre silane de la formule (III)
R⁴ₐSi(OH)₄₋ₐ (III)
dans laquelle R⁴ peut être identique ou différent et possède la signification soit de R¹ définie comme dans la formule (I) soit de R² définie comme dans la formule (I) et dans laquelle l'indice a signifie 1, 2 ou 3.

10. Procédé de production d'une couche tridimensionnelle ou d'un corps moulé tridimensionnel, comprenant les étapes suivantes:
a) préparation d'un substrat ou d'un moule;
b) préparation d'un matériau organiquement modifié renfermant un polysiloxane, qui présente des groupes SH libres et des liaisons doubles C=C isolées,
c) application ou dépôt du matériau préparé sur le substrat ou introduction dudit matériau dans le moule,
d) exposition sélective d'une zone sélectionnée du matériau se trouvant sur le substrat ou dans le moule à l'aide d'une polymérisation à deux photons ou plus,
e) séparation du corps moulé du matériau non exposé par lavage du corps dans un solvant, dans lequel le matériau préparé selon l'étape (b) se dissout.

11. Procédé selon la revendication 10, dans lequel le matériau préparé selon l'étape (b) est sélectionné parmi:
1. un mélange constitué de ou contenant (a) un matériau organiquement modifié renfermant un polysiloxane, présentant des groupes organiques qui sont liés au silicium par l'intermédiaire d'un atome de carbone et qui sont substitués par un ou plusieurs groupe(s) SH, et (b) un composé purement organique, qui présente deux liaisons doubles C=C isolées ou plus,
2. un mélange constitué de ou contenant (a) un matériau organiquement modifié renfermant un polysiloxane, présentant des groupes organiques qui sont liés au silicium par l'intermédiaire de carbone et qui possèdent une ou plusieurs liaison (s) double (s) C=C isolée(s), et (b) un composé purement organique, qui est substitué par deux ou plusieurs groupes SH, et
3. un mélange constitué de ou contenant (a) un matériau organiquement modifié renfermant un polysiloxane, présentant des groupes organiques liés au silicium par l'intermédiaire d'un atome de carbone, qui sont substitués par un ou plusieurs groupe (s) SH, et (b) un matériau organiquement modifié renfermant un polysiloxane, présentant des groupes organiques liés au silicium par l'intermédiaire d'un atome de carbone, qui possèdent une ou plusieurs liaison (s) C=C isolée(s).

12. Procédé selon la revendication 11, dans lequel le matériau préparé selon l'étape (b) comprend un matériau organiquement modifié renfermant un polysiloxane, qui peut être obtenu par hydrolyse et condensation au moins partielle d'un matériau de départ, qui comprend au moins un silane de la formule (I)
R¹ₐR²_{b}SiX_{4-a-b} (I)
dans laquelle R¹ est identique ou différent et représente un radical organique polymérisable par polymérisation à deux photons ou plus, qui porte au moins une liaison double C=C isolée, R² est identique ou différent et représente un radical organique non polymérisable de cette manière, et X est un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un thiosilane ou un thiol organique avec au moins deux groupes SH, ou qui en est constitué,
et/ou
au moins un silane de la formule (I')
R³ₐR²_{b}SiX_{4-a-b} (I')
dans laquelle R³ est identique ou différent et représente un radical organique pouvant être polymérisé par polymérisation à deux photons ou plus, qui porte au moins un groupe SH, R² est identique ou différent et représente un radical organique non polymérisable de cette manière, et X représente un radical hydrolysable à partir du silicium dans des conditions d'hydrolyse, l'indice a signifie 1, 2 ou 3, l'indice b signifie 0, 1 ou 2 et a+b ensemble valent 1, 2 ou 3, ainsi qu'un silane de la formule (I) comme indiqué ci-dessus ou un composé organique contenant au moins une liaison double C=C isolée, ou qui en est constitué.

13. Procédé selon la revendication 12, **caractérisé en ce que** le matériau de départ contient en outre au moins un autre silane de la formule (II)
SiX₄ (II)
dans laquelle X est identique ou différent et possède la même signification que dans la formule (I),
et/ou **en ce que** le matériau de départ contient en outre au moins un autre silane de la formule (III)
R⁴ₐSi(OH)₄₋ₐ (III)
dans laquelle R⁴ peut être identique ou différent et possède la signification soit de R¹ définie comme dans la formule (I) soit de R² définie comme dans la formule (I) et dans laquelle l'indice a signifie 1, 2 ou 3.

14. Procédé selon l'une quelconque des revendications 10 à 13 pour la production d'un corps moulé poreux, en particulier d'un corps moulé avec des pores de l'ordre du µm ou du nm et/ou d'un corps moulé convenant comme échafaudage.

15. Utilisation d'un corps moulé selon l'une quelconque des revendications 1 à 5 comme guide d'ondes.
